(19) Europäisches Patentamt
European Patent Office
Office européen des brevets

(11) EP 1 498 465 A1

(12) **EUROPEAN PATENT APPLICATION**
published in accordance with Art. 158(3) EPC

(43) Date of publication:
**19.01.2005 Bulletin 2005/03**

(21) Application number: **02722757.8**

(22) Date of filing: **24.04.2002**

(51) Int Cl.7: **C09K 11/06**, H05B 33/14, H05B 33/22

(86) International application number:
**PCT/JP2002/004097**

(87) International publication number:
**WO 2003/091357 (06.11.2003 Gazette 2003/45)**

(84) Designated Contracting States:
**AT BE CH CY DE DK ES FI FR GB GR IE IT LI LU MC NL PT SE TR**

(71) Applicant: **Sony Corporation**
**Tokyo 141-0001 (JP)**

(72) Inventors:
- **ISHIBASHI, Tadashi, c/o Sony Corporation Tokyo 141-0001 (JP)**
- **ICHIMURA, Mari, c/o Sony Corporation Tokyo 141-0001 (JP)**
- **TAMURA, Shinichiro, c/o Sony Corporation Tokyo 141-0001 (JP)**
- **UEDA, Naoyuki, c/o Sony Corporation Tokyo 141-0001 (JP)**

(74) Representative: **Müller, Frithjof E., Dipl.-Ing. et al**
**Müller Hoffmann & Partner**
**Patentanwälte**
**Innere Wiener Strasse 17**
**81667 München (DE)**

(54) **ORGANIC ELECTROLUMINESCENT ELEMENT**

(57) The organic electroluminescence device emits a stable red light with high luminance. In the organic electroluminescence device, at least a part of an organic layer (5), (5a), or (5b) having a light emitting area includes a mixture containing at least one of the aminostyryl compound represented by the following general formula [I] or [II],

General formula [I]:

$$Y^1\text{-CH=CH-}X^1\text{-CH=CH-}Y^2$$

General formula [II]:

$$Y^3\text{-CH=CH-}X^2$$

[wherein in the general formulas, $X^1$, $X^2$ represents an aryl group such as anthracene, $Y^1$, $Y^2$, $Y^3$ represents an aryl amino group and the like.]

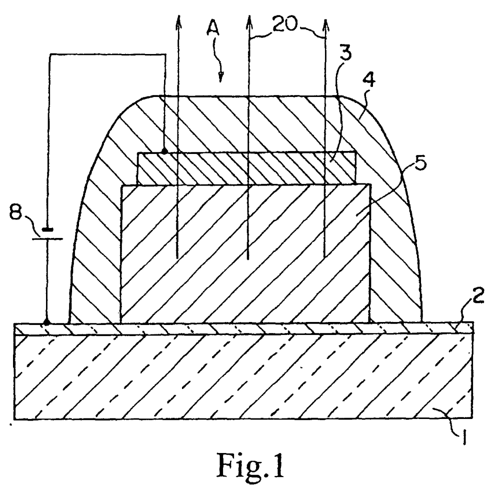

Fig.1

EP 1 498 465 A1

## Description

Technical Field

The present invention relates to an organic electroluminescence device (organic EL device) having an organic layer including an light emitting area disposed between an anode and a cathode.

Background Art

Flat panel displays with light weights and high efficiencies have been studied and developed for use in image displays of computers and televisions.

A cathode ray tube (CRT) is presently most commonly used for a display, since it has high luminance and good color reproducibility. However, the CRT is bulky, heavy, and high electric power consumption.

As the flat panel display with light weight and high efficiency, a liquid display, i.e., an active matrix driven liquid display, is commercially available. However, the liquid display has a narrow angle of visibility, has high electric power consumption in a back light under dark surroundings because it does not emit light spontaneously, has no sufficient response property to highly precise high speed video signals that are expected to be used practically in the near future. In particular, it is difficult to produce a large-seized display, and its costs are high.

As an alternative, a light emitting diode display may be possible. However, its production costs are also high, and a light emitting diode matrix structure is difficult to be formed on one substrate. Therefore, there are many problems to use the light emitting diode practically for replacing with the CRT as a low cost alternative display.

As a flat panel display that may dissolve the above-mentioned problems, an organic electroluminescence device (organic EL device) having an organic light emitting material has been noticed. In other words, it is expected to provide the flat panel display using an organic compound as a light emitting material that emits light spontaneously, has high response speed, and has no dependency on the angle of visibility.

The organic electroluminescence device has a structure that an organic thin film containing an light emitting material, which emits light by a current injection, is formed between a translucent anode and a metal cathode. C. W. Tang, S.A. VanSlyke et al., developed a device having an organic thin film in a two-layered structure comprising a positive hole transport material thin film, and an electron trarisport material thin film that emits light by recombining a hole and an electron injected from respective electrodes to the organic film (organic EL device having a single hetero structure), as described in the research report in Applied Physics Letters, Vol. 51, No. 12, pp. 913 to 915 (1987).

In such device structure, either the positive hole transport material or the electron transport material also acts as a light emitting material. The light is emitted in a wavelength corresponding to an energy gap between a ground state and an excitation sate of the light emitting material. The two-layered structure significantly decreases a driving voltage, and improves light-emitting efficiency.

Thereafter, a three-layered structure having a positive hole transport material, a light emitting material, and an electron transport material (organic EL device having a double hetero structure) has been developed, as described in the research report in Japanese Journal of Applied Physics, Vol. 27, No. 2, pp. L269 to L271 (1988) by C. Adachi, S. Tokita, T. Tsutsui, S. Saito, et al. Furthermore, a device having an electron transport material containing a light emitting material has been developed, as described in the research report in Journal of Applied Physics, Vol. 65, No. 9, pp. 3610 to 3616 (1989) by C. W. Tang, S. A. VanSlyke, C. H. Chen et al. These researches have verified the possibility to emit light with high luminance at low voltage. The research developments have greatly accelerated in recent years.

Theoretically speaking, the organic compound for use in the light emitting material has an advantage that a light emitted color can be optionally changed by alternating a molecular structure. Accordingly, it may be easier to provide three colors R (red), G (green), and B (blue) with good color purity needed for a full color display by designing the molecule, as compared with the thin film EL device using an inorganic substance.

In fact, the organic electroluminescence device, however, has problems to be solved. A device for emitting a red light with stable high luminance is developed with difficulty. One example of a presently available electron transport material is obtained by doping DCM [4-dicyanomethylene-6-(p-dimethyl aminostyryl)-2-methyl-4H-pyran] to tris(8-quinolinol)aluminum (hereinafter referred to as $Alq_3$) (Chem. Funct. Dyes, Proc. Int. Symp., 2nd P.536 (1993)). Such material cannot provide satisfactory maximum luminance and reliability as a display material.

BSB-BCN reported by T. Tsutsui, and D. U. Kim in a conference of Inorganic and Organic electroluminescence (held at Berlin in 1996) provides luminance as high as 1000 cd/$m^2$, but does not provide complete red chromaticity to the full color display.

There is still a desire·for a device for emitting a red light with high luminance, stability, and high color purity.

Japanese Unexamined Patent Application Publication No. 7-188649 (Japanese Patent Application No. 6-148798) suggests that a specific distyryl compound is used as an organic electroluminescence material. The intended

light emitting color is blue, and is not red. On the other hand, there is reported that a hole and an electron are bonded efficiently in the light emitting layer by making an energy containment structure of the hole and the electron in the laminated structure of the organic electroluminescence device to provide a pure light with high luminance, spontaneously emitted from the light emitting material (Japanese Patent Application Nos. 10-79297, 11-204258, 11-204264, 11-204259 and the like). The intended light emitting color is also blue, and is not red.

An object of the present invention is to provide an organic electroluminescence device emitting a stable red or red-like light with high luminance.

A second object of the present invention is to provide an organic electroluminescence device containing a mixture of the compound according to the present invention having an essentially high fluorescence yield, and excellent thermal stability that promotes recombination of a hole and an electron in a light emitting layer, and emits a light with high luminance and high efficiency.

Disclosure of Invention

As a result of intense studies for solving the above-mentioned problems, it has been found that the use of a mixture of a specific styryl compound as a light emitting material, and a material being capable of transmitting energy efficiently can provide a device for emitting a red light with high reliability that is extremely useful for realizing a stable and high luminance full color display. Thus the present invention is achieved.

That is, the present invention is directed to an organic electroluminescence device comprising an organic layer having a light emitting area between an anode and a cathode, wherein at least a part of the organic layer consists of at least one of an aminostyryl compound represented by the following general formula [I] or [II],

General formula [I]:

$$Y^1\text{-CH=CH-}X^1\text{-CH=CH-}Y^2$$

General formula [II]:

$$Y^3\text{-CH=CH-}X^2$$

[wherein in the general formula [I], $X^1$ is a group represented by any of the following general formulas (1) to (4) ,

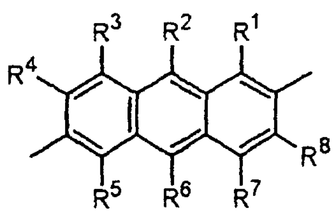

(1)

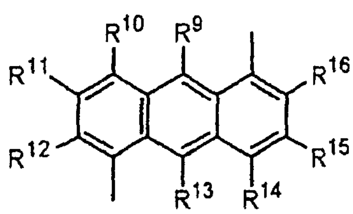

(2)

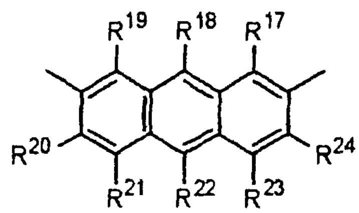

(3)

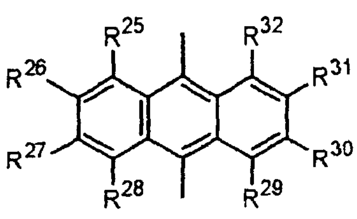

(4)

(wherein in each of $R^1$ to $R^8$, $R^9$ to $R^{16}$, $R^{17}$ to $R^{24}$, and $R^{25}$ to $R^{32}$ in the general formulas (1) to (4), at least one is a halogen atom (for example, fluorine, chlorine, or the like: the same shall apply hereinafter), a nitro group, a cyano

group, a trifluoromethyl group, and the others are groups selected from a hydrogen atom, an alkyl group, an aryl group, an alkoxyl group, a halogen atom, a nitro group, a cyano group, and a trifluoromethyl group, which may be the same or different),

wherein in the general formula [II], $X^2$ is a group represented by any of the following general formulas (5) to (17),

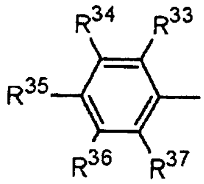

(5)

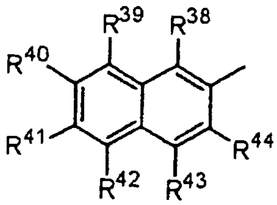

(6)

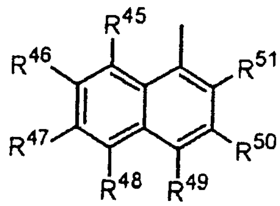

(7)

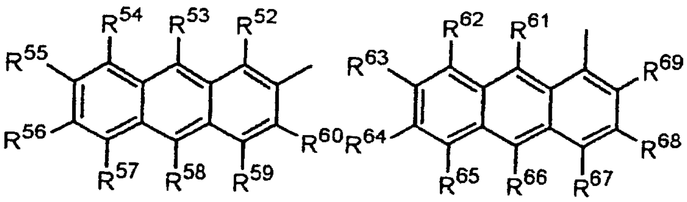

(8)

(9)

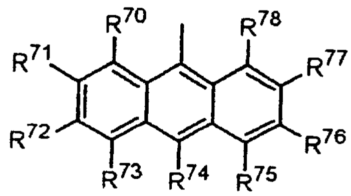

(10)

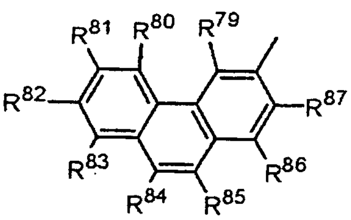

(11)

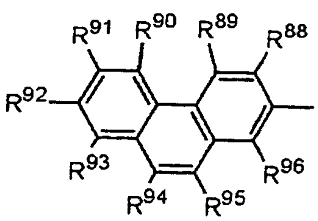

(12)

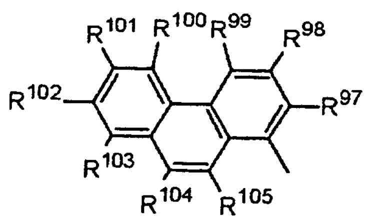

(13)

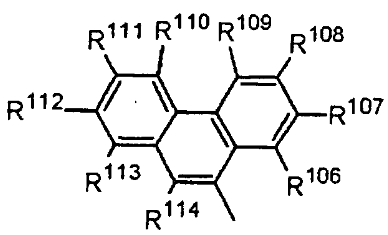

(14)

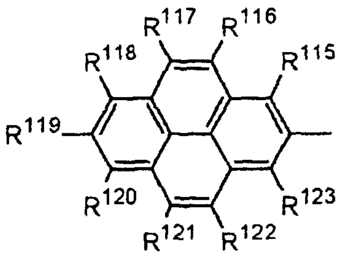
(15)

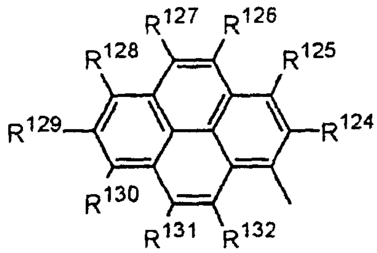
(16)

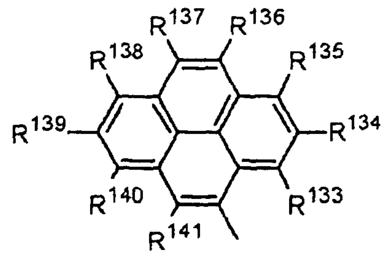
(17)

(wherein in the general formulas (5) to (17), $R^{33}$ to $R^{141}$ are selected from a hydrogen atom, a halogen atom, a nitro group, a cyano group, and a trifluoromethyl group, which may be the same or different),
wherein in the general formulas [I] and [II], $Y^1$, $Y^2$ and $Y^3$ are selected from a hydrogen atom, an alkyl group that may have a substituted group, or an aryl group that may have a substituted group, which may be the same or different,

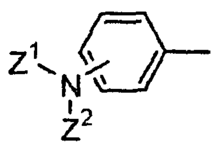
(18)

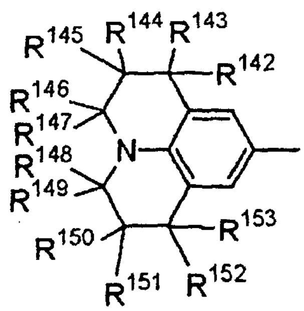
(19)

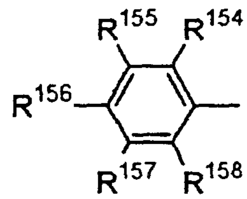
(20)

(wherein in the general formula (18), $Z^1$ and $Z^2$ are selected from a hydrogen atom, an alkyl group that may have a substituted group, or an aryl group that may have a substituted group represented by any of the following general formulas (18) to (20), which may be the same or different, and wherein in the general formulas (19) and (20), $R^{142}$ to $R^{158}$ are groups selected from a hydrogen atom, an alkyl group that may have a substituted group, an aryl group that may have a substituted group, a halogen atom, a nitro group, a cyano group, and a trifluoromethyl group, which may be the same or different)].

The above-mentioned "mixture" herein means a mixture of at least one aminostyryl compound represented by the above general formula [I], and other compound having advantageous properties to achieve the objects of the present invention; a mixture of at least one aminostyryl compound represented by the above general formula [III] and other compound having advantageous properties to achieve the objects of the present invention; a mixture of at least one aminostyryl compound represented by the above general formula [I] and at least one aminostyryl compound represented by the above general formula [II]; or a mixture of at least one aminostyryl compound represented by the above general formula [I], at least one aminostyryl compound represented by the above general formula [II], and other compound having advantageous properties to achieve the objects of the present invention.

The present invention utilizes the mixture containing at least one aminostyryl compound represented by the above general formula [I] or [II] as the light emitting material, whereby there can be provided a device with high luminance that emits a stable red light, and has excellent electrical, thermal, or chemical stability.

The materials usable for forming the mixture containing the aminostyryl compound represented by the above general formula [I] or [II] according to the present invention should not be especially limited. Examples other than the aminostyryl compound represented by the above general formula [I] or [II] according to the present invention include hole transport materials (for example, aromatic amines and the like), electron transport materials (for example, $Alq_3$, pyrazolines and the like), or a series of compounds generally used as a dopant for emitting a red light (DCM and their analogues, porphyrins, phthalocyanines, perylene compounds, Nile red, squalylium compounds), and the like.

The above-mentioned illustrative compounds are used for a material for forming the mixture containing the

aminostyryl compound represented by the above general formula [I] or [II] according to the present invention, whereby the positive hole transport property, the charge transport property, or light emitting property can be improved so that there can be provided a device with high luminance that emits a stable red light, and has more excellent electrical, thermal, or chemical stability.

In the aminostyryl compound represented by the above general formula [I] or [II] for use in the present invention, the $X^1$ (in the above general formulas (1) to (4)) and the $X^2$ (in the above general formulas (5) to (17)) are important in that the light emitting material for use in the present invention emits a red light. For example, the more the number of the benzene ring increases, the more a light emission wavelength of the organic light emitting material tends to shift to a longer wavelength side.

In the organic electroluminescence device, as the aminostyryl compound represented by the above general formulas [I] and [II] that is the light emitting material, at least one of molecular structures such as the following structural formulas (21)-1 to (21)-20:

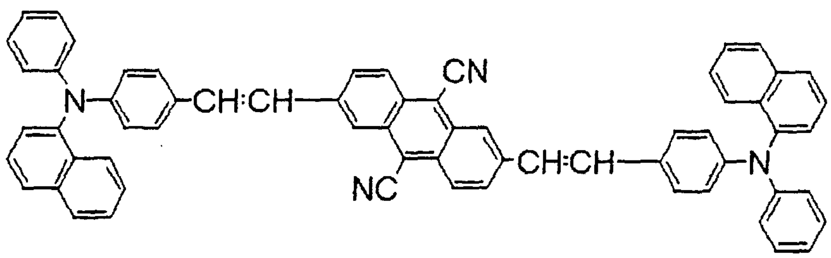

(21)-1

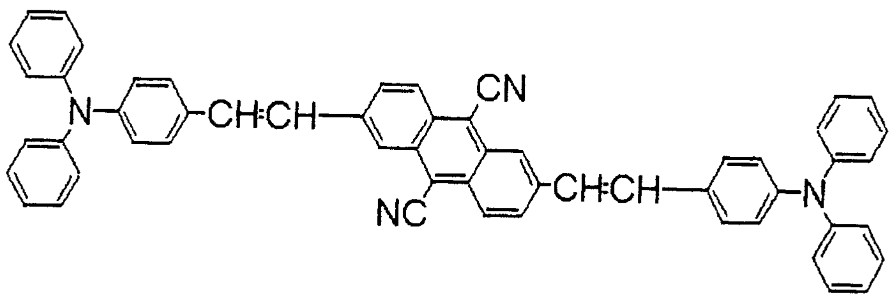

(21)-2

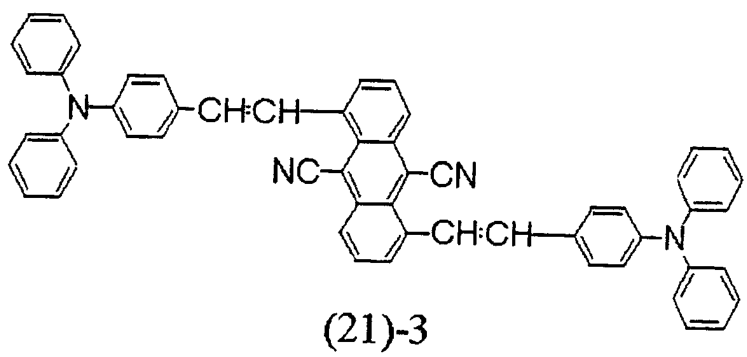

(21)-3

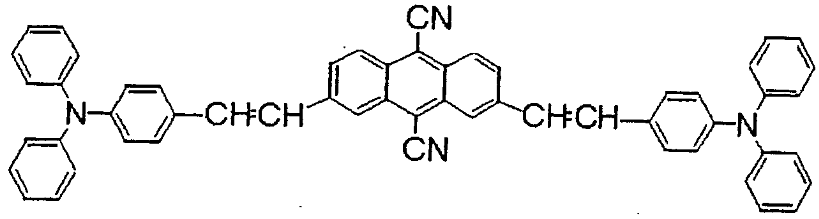

(21)-4

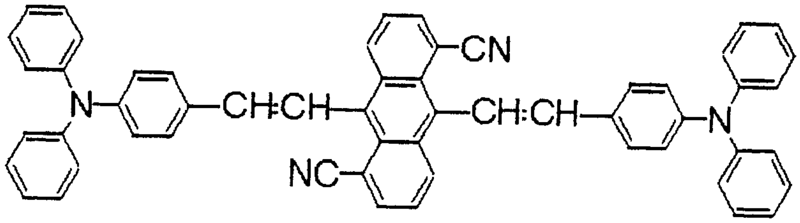

(21)-5

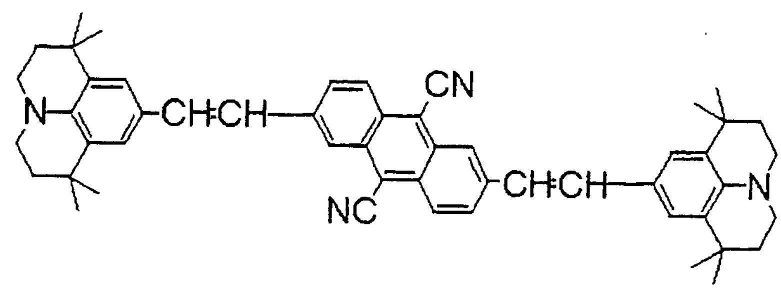

(21)-6

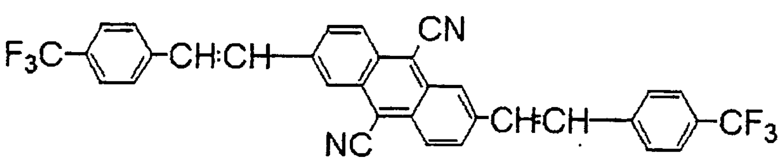

(21)-7

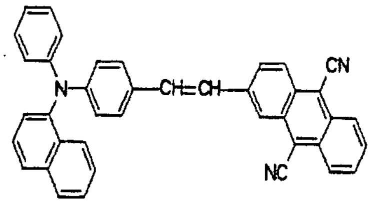

(21)-8

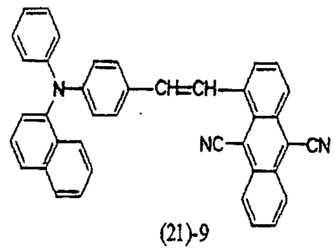

(21)-9

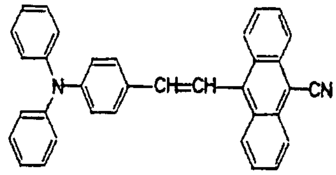

(21)-10

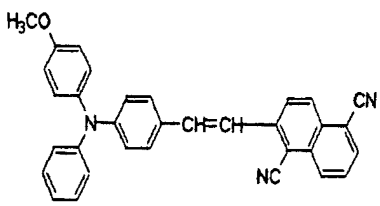

(21)-11

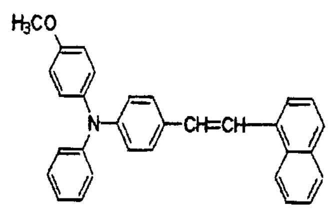

(21)-12

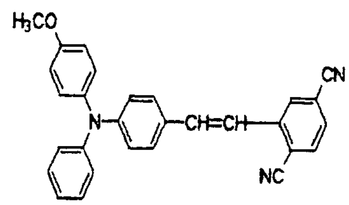

(21)-13

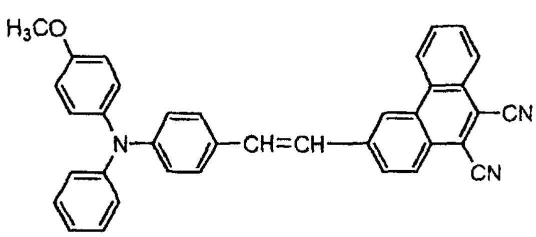

(21)-14

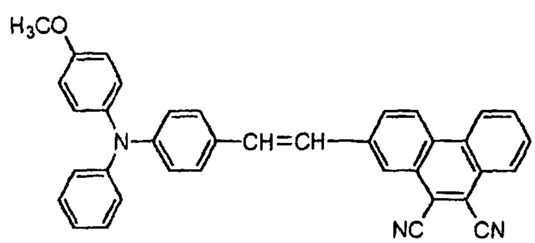

(21)-15

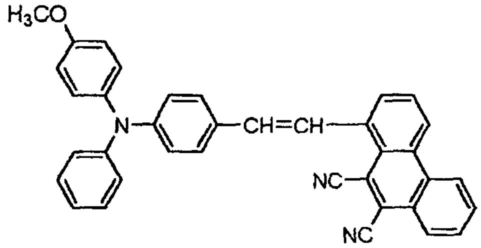

(21)-16

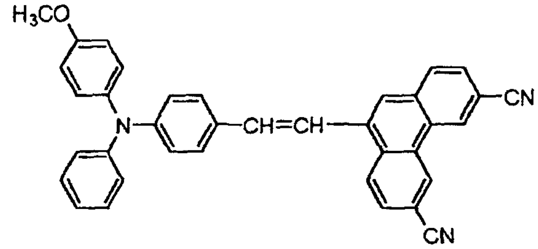

(21)-17

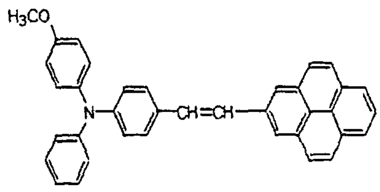

(21)-18

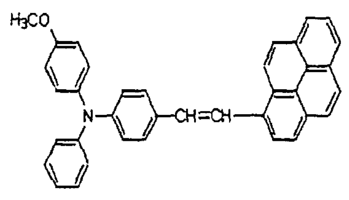

(21)-19

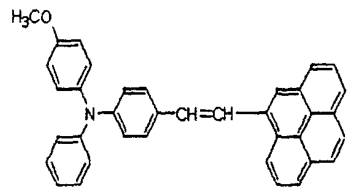

(21)-20

As a result of intense studies for solving the above-mentioned problems by the present inventor, an organic electroluminescence device is produced such that at least one part of an organic layer having a light emitting area is composed of a mixture containing a specific aminostyryl compound and a specific red light emitting dye. Thus, the present invention is achieved that provides more high luminance and high reliability.

In other words, the present invention is directed to an organic electroluminescence device comprising an organic layer having a light emitting area between an anode and a cathode, wherein at least a part of the organic layer consists of a mixture containing at least one of the aminostyryl compound represented by the above structural formulas (21)-1 to (21)-20, and a red light emitting dye having a light emission maximum within the range of 600 nm to 700 nm.

Any red light emission dyes having a light emission maximum within the range of 600 nm to 700 nm can be used, and are not limited thereto. As described above, examples include a series of compounds generally used as a dopant for emitting a red light (DCM and their analogues, porphyrins, phthalocyanines, perylene compounds, Nile red, squalylium compounds), and the like.

The use of the above-mentioned red light emitting dye can enhance the light emitting property, and can provide a stable red emitting light with more high luminance.

In the present invention, the organic layer has an organic laminated structure having a hole transport layer and an electron transport layer, wherein the electron transport layer of the organic layer may be at least a mixture layer containing at least one of the aminostyryl compound represented by the above general formula [I] or [II], and the aminostyryl compound represented by structural formulas (21)-1 to (21)-20.

The organic layer has the organic laminated structure having the hole transport layer and the electron transport layer, wherein the hole transport layer of the organic layer may be at least a mixture layer containing at least one of the aminostyryl compound represented by the above general formula [I] or [II], and the aminostyryl compound represented by structural formulas (21)-1 to (21)-20.

The organic layer has the organic laminated structure having the hole transport layer and the electron transport layer, wherein the hole transport layer of the organic layer may be at least a mixture layer containing at least one of the aminostyryl compound represented by the above general formula [I] or [II], and the aminostyryl compound represented by structural formulas (21)-1 to (21)-20, and the electron transport layer of the organic layer may be at least a mixture layer containing at least one of the aminostyryl compound represented by the above general formula [I] or [II], and the aminostyryl compound represented by structural formulas (21)-1 to (21)-20.

The organic layer has the organic laminated structure having the hole transport layer, a light emitting layer, and the electron transport layer, wherein the light emitting layer of the organic layer may be at least a mixture layer containing at least one of the aminostyryl compound represented by the above general formula [I] or [II], and the aminostyryl compound represented by structural formulas (21)-1 to (21)-20.

In the present invention, the percentage of the aminostyryl compound in the mixture is preferably 10 to 100% by weight.

According to the present invention, a hole (positive hole) blocking layer is disposed on the cathode side of the light emitting layer in the organic electroluminescence device containing the mixture of the present invention having a substantially high fluorescence yield, and excellent thermal stability. Thus, the hole and the electron are recombined efficiently in the light emitting layer, which leads to provide the organic electroluminescence device that the light emitting material emits a pure light spontaneously with high luminance and high efficiency.

In other words, the present invention provides an organic electroluminescence device comprising an organic layer including an light emitting area disposed between an anode and a cathode, wherein at least a part of the organic layer consists a mixture containing at least one of the aminostyryl compound represented by the general formula [I] or [II] (the same shall apply hereinafter), or the above structural formulas (21)-1 to (21)-20 (the mixture may contain the above-mentioned red light emitting dye having a light emission maximum within the range of 600 nm to 700 nm: the same shall apply hereinafter), and wherein a hole blocking layer is disposed on the cathode side of the layer comprising

the mixture.

For example, the organic layer has an organic laminated structure having a hole transport layer and an electron transport layer, wherein the electron transport layer of the organic layer may be at least a mixture layer containing at least one aminostyryl compound represented by the above general formula [I] or [II], and the hole blocking layer can be disposed on the cathode side of the layer comprising the mixture.

The organic layer has an organic laminated structure having a hole transport layer and an electron transport layer, wherein the hole transport layer of the organic layer may be at least a mixture layer containing at least one aminostyryl compound represented by the above general formula [I] or [II], and the hole blocking layer can be disposed on the cathode side of the layer comprising the mixture.

The organic layer has an organic laminated structure having a hole transport layer and an electron transport layer, wherein the hole transport layer of the organic layer may be at least a mixture layer containing at least one aminostyryl compound represented by the above general formula [I] or [II], the electron transport layer of the organic layer may be at least a mixture layer containing at least one aminostyryl compound represented by the above general formula [I] or [II], and the hole blocking layer can be disposed on the cathode side of the layer comprising the mixture.

The organic layer has the organic laminated structure having the hole transport layer, a light emitting layer, and the electron transport layer, wherein the light emitting layer of the organic layer may be at least a mixture layer containing at least one of the aminostyryl compound represented by the above general formula [I] or [II], and the hole blocking layer is disposed on the cathode side of the layer comprising the mixture.

In the present invention, the percentage of the aminostyryl compound in the mixture is preferably 10 to 100% by weight.

The material suitable for the hole blocking layer has desirably the following energy states: the highest occupied molecular orbital of the material for forming the hole blocking layer has lower energy level than that of the highest occupied molecular orbital of the material for forming the layer on the anode side of the hole blocking layer, and/or the lowest unoccupied molecular orbital of the material for forming the hole blocking layer has higher energy level than that of the lowest unoccupied molecular orbital of the material for forming the layer on the anode side of the hole blocking layer, and has lower energy level than that of the lowest unoccupied molecular orbital of the material for forming the layer on the cathode side of the hole blocking layer.

Such material includes a phenanthroline derivative described in Japanese Unexamined Patent Application Publication Nos. 10-79297, 11-204258, 11-204264, 11-204259, and the like. However, it is not limited thereto, as long as the above-mentioned conditions are satisfied.

Brief Description of the Drawings

Fig. 1 is a schematic main sectional view of an example of the organic electroluminescence device according to the present invention.

Fig. 2 is a schematic main sectional view of other example of the organic electroluminescence device according to the same.

Fig. 3 is a schematic main sectional view of other example of the organic electroluminescence device according to the same.

Fig. 4 is a schematic main sectional view of other example of the organic electroluminescence device according to the same.

Fig. 5 is a schematic main sectional view of other example of the organic electroluminescence device according to the same.

Fig. 6 is a schematic main sectional view of other example of the organic electroluminescence device according to the same.

Fig. 7 is a schematic main sectional view of other example of the organic electroluminescence device according to the same.

Fig. 8 is a schematic main sectional view of still other example of the organic electroluminescence device according to the same.

Fig. 9 is a view of a full color flat display using the organic electroluminescence device according to the same.

Best Mode for Carrying Out the Invention

Figs. 1 to 4, and 5 to 8 show examples of the organic electroluminescence device according to the present invention, respectively.

Fig. 1 shows a transmission type organic electroluminescence device A in which an emitted light 20 transmits

through a cathode 3. The emitted light 20 can be observed at a side of a protective layer 4. Fig. 2 shows a reflection type organic electroluminescence device B in which a reflected light at the cathode 3 is obtained as the emitted light 20.

In the figures, reference numeral 1 is a substrate for forming the organic electroluminescence device. Glass, plastic, and other suitable materials can be used. If the organic electroluminescence device is used in combination with other display device, the substrate can be shared. Reference numeral 2 is a transparent electrode (anode). ITO (Indium tin oxide), $SnO_2$ and the like can be used.

Reference numeral 5 is an organic light emitting layer, and contains the mixture including the above-mentioned aminostyryl compounds as the light emitting material. The light emitting layer can have conventionally known various structures for providing the organic electroluminescence light 20. As described later, if the material constituting either the hole transport layer, or the electron transport layer has, for example, light emitting property, these thin films can be laminated. In order to enhance the charge transport property as long as the objects of the present invention are achieved, either the positive hole transport layer or the electron transport layer or both may have a structure where thin films of a plurality of materials are laminated, or may use the thin films consisting of the mixed compositions of a plurality of materials. In order to enhance the light emitting property, using at least one or more fluorescent materials, the thin film may be sandwiched between the positive hole transport layer and the electron transport layer, or at least one or more fluorescent materials may be contained in the positive hole transport layer or the electron transport layer, or both. In these cases, it is possible to include the thin films for controlling the transport of the positive hole or the electron, in order to improve luminous efficiency.

For example, the aminostyryl compounds represented by the above structural formulas (21) have both electron transport property and positive hole transport property. Accordingly, in the device, the light emitting layer consisting of the mixture containing the above-mentioned aminostyryl compounds can also be used as the electron transport layer, or the positive hole transport layer. It is also possible that the mixture containing the above-mentioned aminostyryl compounds is sandwiched between the electron transport layer and the positive hole transport layer as the light emitting layer. In Figs. 5 and 6, a hole blocking layer 21 consisting of a phenanthroline derivative is disposed on the cathode side of the light emitting layer 5, in addition to the above structure.

In Figs. 1, 2, 5 and 6, 3 is the cathode. As a material for an electrode, active metals such as Li, Mg, Ca and the like; alloys with metals such as Ag, Al, In, and the like, or laminated structures thereof can be used. In the transmission type organic electroluminescence device, light transmittance suitable for the applications can be obtained by controlling the thickness of the cathode. In the figures, the protective film 4 is a layer for seal and protection. When the protective film 4 overlaps the whole organic electroluminescence device, the effectiveness is enhanced. As long as airtightness is kept, any suitable materials can be used. 8 is a driving power supply for injecting a current.

In the organic electroluminescence device according to the present invention, the organic layer has an organic laminated structure (single hetero structure) where the positive hole transport layer and the electron transport layer are laminated, and the mixture containing the aminostyryl compound may be used as the material for forming the positive hole transport layer or the electron transport layer. Alternatively, the organic layer has an organic laminated structure (double hetero structure) where the positive hole transport layer, the light emitting layer, and the electron transport layer are sequentially laminated, and the mixture containing the styryl compound may be used as the material for forming the light emitting layer.

Examples of the organic electroluminescence device such structures are illustrated. Fig. 3 is an organic electroluminescence device with the single hetero structure C including a laminated structure where a translucent anode 2, an organic layer 5a consisting of a positive hole transport layer 6 and an electron transport layer 7, and a cathode 3 are sequentially laminated on a translucent substrate 1, and the laminated structure is sealed with the protective film 4. In Fig. 7, the hole blocking layer 21 is disposed on the cathode side of the electron transport layer 7 and/or the positive hole transport layer 6.

In the case that the light emitting layer is omitted as shown in Figs. 3 and 7, the emitted light 20 with the predetermined wavelength is produced from an interface between the positive hole transport layer 6 and the electron transport layer 7. The emitted light is observed at the substrate 1.

Fig. 4 is an organic electroluminescence device with the double hetero structure D including a laminated structure where a translucent anode 2, an organic layer 5a consisting of a positive hole transport layer 10, a light emitting layer 11, and an electron transport layer 12, and a cathode 3 are sequentially laminated on a translucent substrate 1, and the laminated structure is sealed with the protective film 4. In Fig. 8, the hole blocking layer 21 is disposed on the cathode side of the light emitting layer 11.

In the organic electroluminescence device shown in Fig. 4, a voltage direct current is applied between the anode 2 and the cathode 3, whereby the positive holes injected from the anode 2 and the electrons injected from the cathode 3 reach to the light emitting layer 11 through the positive hole transport layer 10 and the electron transport layer 12, respectively. As a result, in the light emitting layer 11, the electrons/positive holes are recombined to generate singlet excitons, from which the light with the predetermined wavelength is emitted.

In the above-mentioned organic electroluminescence devices C and D, the substrate 1 may be made, for

example, of a light transparent material such as glass, plastic, and the like, as required. If other display device is used in combination therewith, or if the laminated structures shown in Figs. 3, 4, 7, and 8 are disposed in a matrix, the substrate may be shared. The device C, or D can be the transmission type, or the reflection type.

The anode 2 is a transparent electrode (anode). ITO (indium tin oxide), $SnO_2$ and the like can be used. A thin film consisting of an organic substance, or an organic metal compound may be formed between the anode 2 and the positive hole transport layer 6 (or the positive hole transport layer 10), in order to improve the charge injection efficiency. When the protective film 4 is formed with a conductive material such as metals, an insulation film may be disposed at the side of the anode 2.

The organic layer 5a in the organic electroluminescence device C is the organic layer on which the positive hole transport layer 6 and the electron transport layer 7 are laminated. Either or both of them contain the mixture including the above-mentioned aminostyryl compounds so that the light emitting positive hole transport layer 6 or the electron transport layer 7 is provided. The organic layer 5b in the organic electroluminescence device D is the organic layer in which the positive hole transport layer 10, the light emitting layer 11 containing the mixture including the above-mentioned aminostyryl compound 11, and the electron transport layer 12 are laminated. Any other various laminated structures may be utilized. For example, either or both of the positive hole transport layer and the electron transport layer may have light emitting property.

In the positive hole transport layer, a positive hole transport layer on which a plurality of positive hole transport materials are laminated, in order to enhance the positive hole transport property.

In the organic electroluminescence device C, the light emitting layer may be the electron transport layer 7. However, the light is emitted at the positive hole transport layer 6, or at its interface, depending on the voltage applied by the power supply 8. Similarly, in the organic electroluminescence device D, the light emitting layer may be the electron transport layer 12, or the positive hole transport layer 10 other than the light emitting layer 11. In order to enhance the light emitting property, the light emitting layer 11 made of at least one fluorescent material may be sandwiched between the positive hole transport layer and the electron transport layer. Alternatively, the fluorescent material may be contained in the positive hole transport layer or the electron transport layer or both. In this case, the layer can include a thin film (a hole blocking layer or an exciton producing layer) for controlling the transport of the positive hole and the electron, in order to improve the light emitting efficiency.

The material for use in the cathode 3 can be active metals such as Li, Mg, Ca and the like; alloys with metals such as Ag, Al, In, and the like, or laminated structures thereof. The organic electroluminescence device suitable for certain application can be produced by selecting the thickness or the material of the cathode, as required.

The protective film 4 acts as a sealing film. The protective film 4 overlaps the whole organic electroluminescence device, whereby the charge injecting efficiency and the light emitting efficiency can be enhanced. As long as airtightness is kept, any suitable materials such as single metal including aluminum, gold, chromium, and the like, or alloys can be used.

The current applied for each of the above-described organic electroluminescence devices is generally a voltage direct current, but may be a pulse current or an alternating current. The current value, and the voltage value are not especially limited as long as the device is not failed. It is desirable that the light be emitted efficiently using electric energy as small as possible, with the electric power consumption and the lifetime of the organic electroluminescence device taken into consideration.

Fig. 9 shows an illustration of a flat display using the organic electroluminescence device according to the present invention. As shown in the figure, in the case of the full color display, for example, light emitting layers 5 (organic layer 5a, organic layer 5b) that can emit three primary colors, i.e., red (R), green (G), and blue (B) are disposed between the cathodes 3 and the anodes 2. The cathodes 3 and the anodes 2 can be formed in a stripe pattern such that they are intersected each other. Each of the cathode 3 and the anode 2 is selected by a luminance signal circuit 14 and a control circuit 15 including a shift resistor, and applied a signal voltage, whereby the organic layer emits light at a intersection point (pixel) of the cathode 3 and the anode 2 selected.

That is, Fig. 9 shows, for example, an 8 x 3 RGB simple matrix, where the light emitting layers 5 each consisting of the positive hole transport layer, and either, or at least one of the light emitting layer and the electron transport layer are disposed between the cathodes 3 and the anodes 2 (refer to Figs. 3 and 7, or 4 and 8). The cathodes and the anodes are patterned in a stripe shape, are crossed in a matrix. The signal voltage is applied thereto in time series by a control circuit 15 including a shift resistor and the luminance signal circuit 14, and the light is emitted at the intersection point. The EL device having such construction can be used not only for a device for displaying characters, marks, and the like, but also for an image reproducing device. Alternatively, the stripe-like patterns of the cathodes 3 and the anodes 2 are formed per each color, i.e., red (R), green (G), and blue (B). Thus, a multiple color, or full color all solid flat panel display can be constructed.

Next, the present invention will be described in detail with reference to examples, but is not limited to the following examples.

EXAMPLE 1

In this example, an organic electroluminescence device with the single hetero structure was produced using a mixture of the aminostyryl compound represented by the following structural formula (21)-1 among the aminostyryl compounds represented by the general formula [I], and α-NPD (α-naphthyl phenyl diamine) using as the positive hole transport light emitting layer.
Structural formula (21)-1:

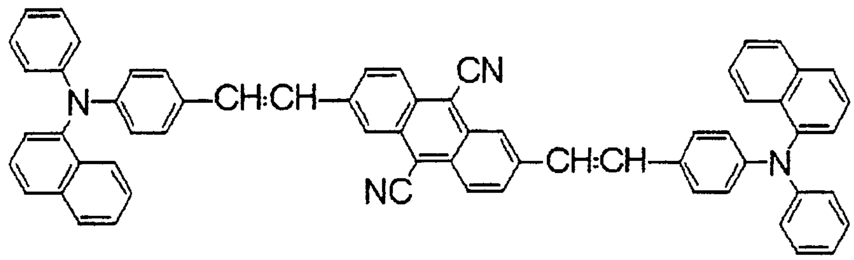

(21)-1

α-NPD

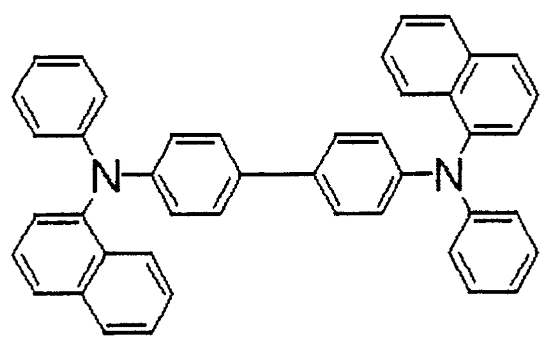

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer (that also acted as a light emitting layer), for example, with a thickness of 50 nm was formed using the above structural formula (21)-1 and the α-NPD that was a material for the hole transport layer at a weight ratio of 1:1 under a vacuum of $10^{-4}$ Pa or less by a vapor deposition method. Respective vapor deposition rates were 0.1 nm/sec.

Further, as a material for an electron transport layer, $Alq^3$ (tris(8-quinolinol)aluminum) having the following structural formula was vapor deposited on the positive hole transport layer. The electron transport layer consisting of the $Alq^3$ had, for example, a thickness of 50 nm, and a vapor deposition rate was 0.2 nm/sec.
$Alq^3$:

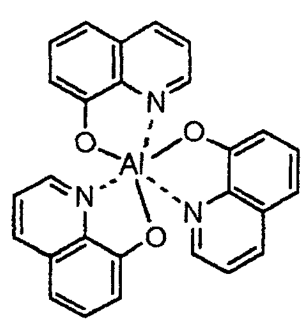

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 1, the organic electroluminescence device as shown in Fig. 3 was produced.

Thus-produced organic electroluminescence device of EXAMPLE 1 was evaluated for light emitting property by applying a forward bias voltage direct current under vacuum atmosphere. The emitted light was red. As a result of spectrometry, there was obtained a spectrum having a light emitting peak at near 680 nm. In the spectrometry, a spectrometer that used a photo diode array manufactured by Otsuka Denshi KK as a detector was used. A voltage-luminance measurement was made to provide the luminance of 500 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 250 hours.

EXAMPLE 2

In this example, an organic electroluminescence device with the single hetero structure was produced using a mixture of the aminostyryl compound represented by the above structural formula (21)-1 among the aminostyryl compounds represented by the general formula [I], and $Alq_3$ using as the electron transport light emitting layer.

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer, for example, with a thickness of 50 nm was formed using the $\alpha$-NPD of the above structural formula under a vacuum of $10^{-4}$ Pa or less by a vapor deposition method. A vapor deposition rate was 0.1 nm/sec.

Further, the aminostyryl compound represented by the above structural formula (21)-1 and $Alq^3$ that was an electron transport material were vapor deposited at a weight ratio of 1:1 on the positive hole transport layer. The electron transport layer (that also acted as a light emitting layer) consisting of the mixture of the aminostyryl compound represented by the above structural formula (21)-1 and the $Alq^3$ had, for example, a thickness of 50 nm, and respective vapor deposition rates were 0.2 nm/sec.

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 2, the organic electroluminescence device as shown in Fig. 3 was produced.

Thus-produced organic electroluminescence device of EXAMPLE 2 was evaluated for light emitting property by applying a forward bias voltage direct current under vacuum atmosphere. The emitted light was red. As a result of the same spectrometry as in EXAMPLE 1, there was obtained a spectrum having a light emitting peak at near 690 nm. A voltage-luminance measurement was made to provide the luminance of 600 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 200 hours.

EXAMPLE 3

In this example, an organic electroluminescence device with the double hetero structure was produced using a mixture of the aminostyryl compound represented by the above structural formula (21)-1 among the aminostyryl compounds represented by the general formula [I], and $Alq_3$ using as the electron transport light emitting layer.

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer, for example, with a thickness of 30 nm was formed using the $\alpha$-NPD of the above structural formula under a vacuum of $10^{-4}$ Pa or less by a vapor deposition method. A vapor deposition rate was 0.2 nm/sec.

Further, the aminostyryl compound represented by the above structural formula (21)-1 and $Alq^3$ that was an electron transport material were vapor deposited at a weight ratio of 1:1 on the positive hole transport layer. The light emitting layer consisting of the aminostyryl compound represented by the above structural formula (21)-1 and the $Alq^3$ had, for example, a thickness of 30 nm, and respective vapor deposition rates were 0.2 nm/sec.

As the electron transport material, the $Alq^3$ having the above structural formula was vapor deposited on the light emitting layer. The $Alq^3$ had, for example, a thickness of 30 nm, and a vapor deposition rate was 0.2 nm/sec.

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 3, the organic electroluminescence device as shown in Fig. 4 was produced.

Thus-produced organic electroluminescence device of EXAMPLE 3 was evaluated for light emitting property by applying a forward bias voltage direct current under vacuum atmosphere. The emitted light was red. As a result of the spectrometry, there was obtained a spectrum having a light emitting peak at 690 nm. A voltage-luminance measurement was made to provide the luminance of 800 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 500 hours.

EXAMPLE 4

In this example, an organic electroluminescence device with the double hetero structure was produced using a mixture of the aminostyryl compound represented by the following structural formula (21)-8 and the aminostyryl compound represented by the above structural formula (21)-1 among the aminostyryl compounds represented by the general formula [I] or [II] using as the light emitting layer.

Structural formula (21)-8:

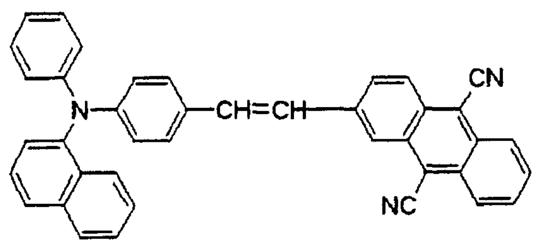

(21)-8

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer, for example, with a thickness of 30 nm was formed using the α-NPD of the above structural formula under a vacuum of $10^{-4}$ Pa or less by a vapor deposition method. A vapor deposition rate was 0.2 nm/sec.

Further, the aminostyryl compounds represented by the above structural formula (21)-8 and by the above structural formula (21)-1 that were the light emitting material were vapor deposited at a weight ratio of 1:3 on the positive hole transport layer. The light emitting layer consisting of the mixture of the aminostyryl compounds represented by the above structural formula (21)-8 and by the above structural formula (21)-1 had, for example, a thickness of 30 nm. A vapor deposition rate of the compound represented by the above structural formula (21)-8 was 0.1 nm/sec, and a vapor deposition rate of the compound represented by the above structural formula (21)-1 was 0.3 nm/sec.

As the electron transport material, the $Alq^3$ having the above structural formula was vapor deposited on the light emitting layer. The $Alq^3$ had, for example, a thickness of 30 nm, and a vapor deposition rate was 0.2 nm/sec.

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 4, the organic electroluminescence device as shown in Fig. 4 was produced.

Thus-produced organic electroluminescence device of EXAMPLE 4 was evaluated for light emitting property by applying a forward bias voltage direct current under vacuum atmosphere. The emitted light was red. As a result of the spectrometry, there was obtained a spectrum having a light emitting peak at 710 nm. A voltage-luminance measurement was made to provide the luminance of 300 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 200 hours.

EXAMPLE 5

In this example, an organic electroluminescence device with the double hetero structure was produced using

a mixture (weight ratio 1:3) of the aminostyryl compound represented by the following structural formula (21)-9 and the aminostyryl compound represented by the following structural formula (21)-2 among the aminostyryl compounds represented by the general formula [I] or [II] using as the light emitting layer. The organic electroluminescence device was produced in accordance with the layer structure and the film forming method in EXAMPLE 4.
Structural formula (21)-2:

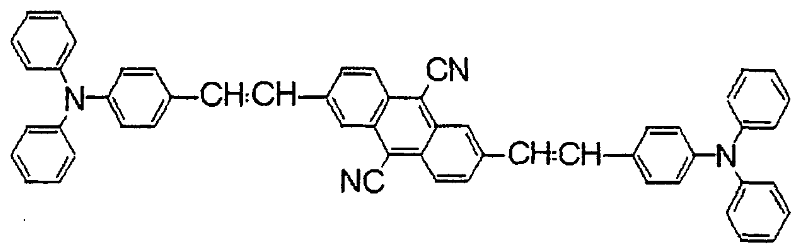

(21)-2

Structural formula (21)-9:

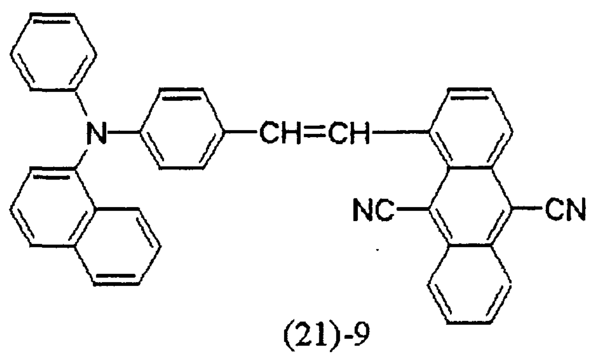

(21)-9

Thus-produced organic electroluminescence device of EXAMPLE 5 was evaluated for light emitting property by applying a forward bias voltage direct current under vacuum atmosphere. The emitted light was red. As a result of the spectrometry, there was obtained a spectrum having a light emitting peak at 750 nm. A voltage-luminance measurement was made to provide the luminance of 20 cd/$m^2$ at 8V.
After the organic electroluminescence device was produced, it was allowed to stand for one month under nitrogen atmosphere. No device degradation was observed. The organic electroluminescence device was electrified with a uniform current value at initial luminance of 20 cd/$m^2$ to emit light continuously, and forced deterioration. A time for decreasing the luminance to half was 100 hours.

EXAMPLE 6

In this example, an organic electroluminescence device with the double hetero structure was produced using a mixture (weight ratio 1:3) of the aminostyryl compound represented by the following structural formula (21)-10 and the aminostyryl compound represented by the following structural formula (21)-3 among the aminostyryl compounds represented by the general formula [I] or [II] using as the light emitting layer. The organic electroluminescence device was produced in accordance with the layer structure and the film forming method in EXAMPLE 4.
Structural formula (21)-3:

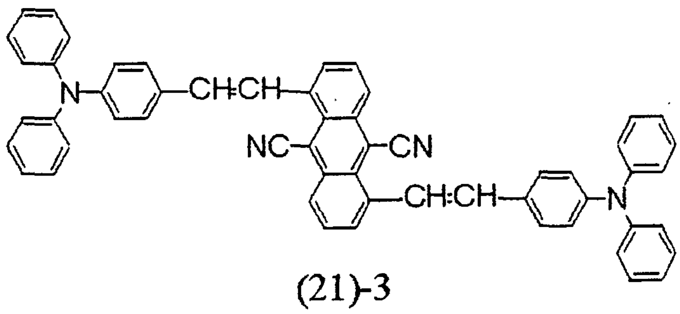

(21)-3

Structural formula (21)-10:

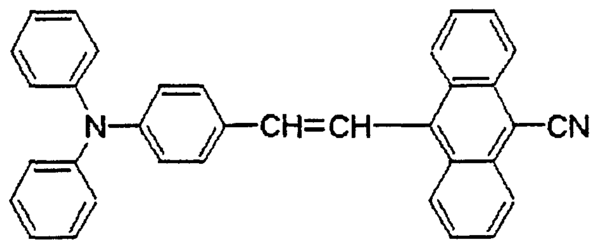

(21)-10

Thus-produced organic electroluminescence device of EXAMPLE 6 was evaluated for light emitting property by applying a forward bias voltage direct current under vacuum atmosphere. The emitted light was orange. As a result of the spectrometry, there was obtained a spectrum having a light emitting peak at 620 nm. A voltage-luminance measurement was made to provide the luminance of 500 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 250 hours.

EXAMPLE 7

In this example, an organic electroluminescence device with the double hetero structure was produced using a mixture (weight ratio 1:3) of the aminostyryl compound represented by the following structural formula (21)-11 and the aminostyryl compound represented by the following structural formula (21)-4 among the aminostyryl compounds represented by the general formula [I] or [II] using as the light emitting layer. The organic electroluminescence device was produced in accordance with the layer structure and the film forming method in EXAMPLE 4.

Structural formula (21)-4:

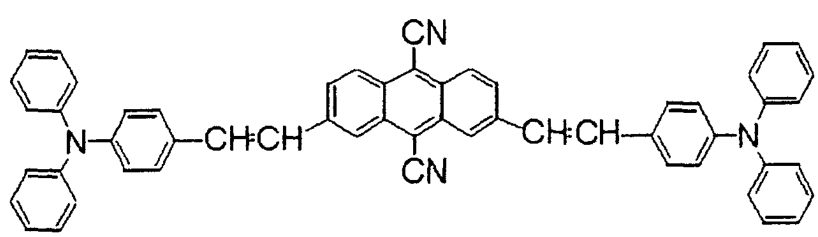

(21)-4

Structural formula (21)-11:

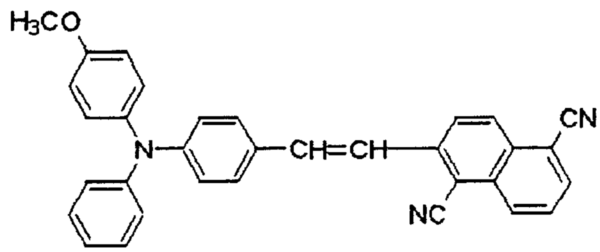

(21)-11

Thus-produced organic electroluminescence device of EXAMPLE 7 was evaluated for light emitting property by applying a forward bias voltage direct current under vacuum atmosphere. The emitted light was red. As a result of the spectrometry, there was obtained a spectrum having a light emitting peak at 660 nm. A voltage-luminance measurement was made to provide the luminance of 250 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 100 hours.

EXAMPLE 8

In this example, an organic electroluminescence device with the double hetero structure was produced using a mixture (weight ratio 1:3) of the aminostyryl compound represented by the following structural formula (21)-13 and the aminostyryl compound represented by the following structural formula (21)-5 among the aminostyryl compounds represented by the general formula [I] or [II] using as the light emitting layer. The organic electroluminescence device was produced in accordance with the layer structure and the film forming method in EXAMPLE 4.
Structural formula (21)-5:

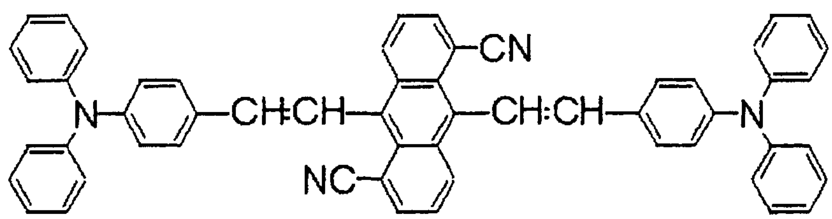

(21)-5

Structural formula (21)-13:

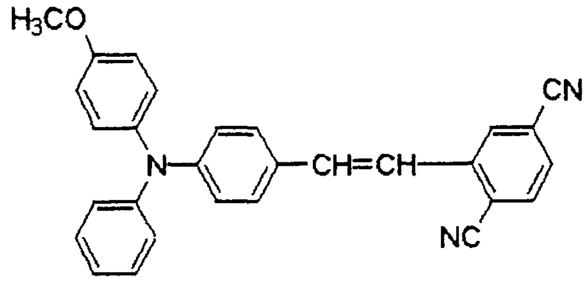

(21)-13

Thus-produced organic electroluminescence device of EXAMPLE 8 was evaluated for light emitting property by applying a forward bias voltage direct current under vacuum atmosphere. The emitted light was red. As a result of the spectrometry, there was obtained a spectrum having a light emitting peak at 615 nm. A voltage-luminance measurement was made to provide the luminance of 320 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 150 hours.

EXAMPLE 9

In this example, an organic electroluminescence device with the double hetero structure was produced using a mixture (weight ratio 1:3) of the aminostyryl compound represented by the following structural formula (21)-14 and the aminostyryl compound represented by the following structural formula (21)-6 among the aminostyryl compounds represented by the general formula [I] or [II] using as the light emitting layer. The organic electroluminescence device was produced in accordance with the layer structure and the film forming method in EXAMPLE 4.
Structural formula (21)-6:

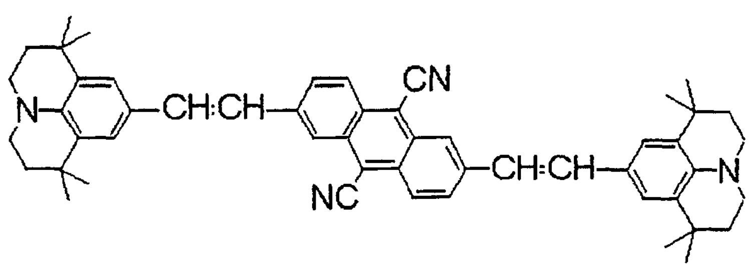

(21)-6

Structural formula (21)-14:

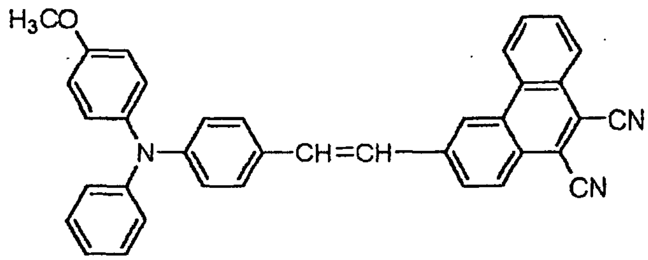

(21)-14

Thus-produced organic electroluminescence device of EXAMPLE 9 was evaluated for light emitting property by applying a forward bias voltage direct current under vacuum atmosphere. The emitted light was red. As a result of the spectrometry, there was obtained a spectrum having a light emitting peak at 670 nm. A voltage-luminance measurement was made to provide the luminance of 230 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 170 hours.

EXAMPLE 10

In this example, an organic electroluminescence device with the double hetero structure was produced using a mixture (weight ratio 1:3) of the aminostyryl compound represented by the following structural formula (21)-15 and the aminostyryl compound represented by the following structural formula (21)-7 among the aminostyryl compounds represented by the general formula [I] or [II] using as the light emitting layer. The organic electroluminescence device was produced in accordance with the layer structure and the film forming method in EXAMPLE 4.
Structural formula (21)-7:

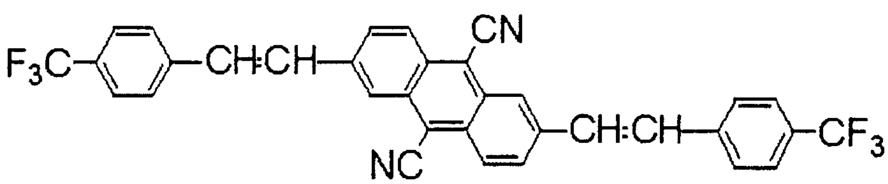

(21)-7

Structural formula (21)-15:

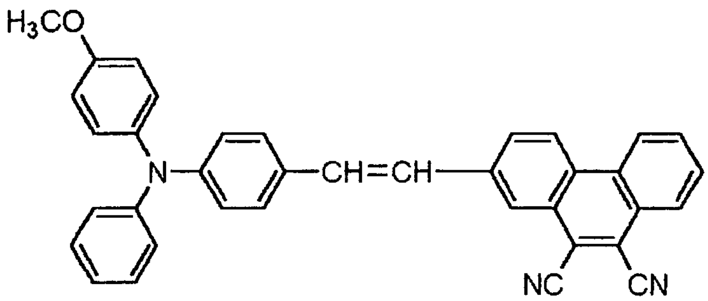

(21)-15

Thus-produced organic electroluminescence device of EXAMPLE 10 was evaluated for light emitting property by applying a forward bias voltage direct current under vacuum atmosphere. The emitted light was red. As a result of the spectrometry, there was obtained a spectrum having a light emitting peak at 630 nm. A voltage-luminance measurement was made to provide the luminance of 700 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 300 hours.

EXAMPLE 11

In this example, an organic electroluminescence device with the double hetero structure was produced using a mixture (weight ratio 1:3) of the aminostyryl compound represented by the following structural formula (21)-18 and the aminostyryl compound represented by the above structural formula (21)-1 among the aminostyryl compounds represented by the general formula [I] or [II] using as the light emitting layer. The organic electroluminescence device was produced in accordance with the layer structure and the film forming method in EXAMPLE 4.
Structural formula (21)-18:

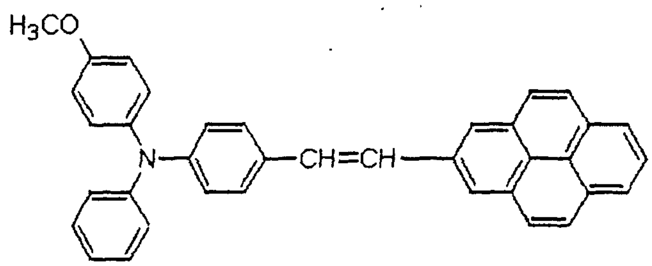

(21)-18

Thus-produced organic electroluminescence device of EXAMPLE 11 was evaluated for light emitting property by applying a forward bias voltage direct current under vacuum atmosphere. The emitted light was red. As a result of the spectrometry, there was obtained a spectrum having a light emitting peak at 640 nm. A voltage-luminance measurement was made to provide the luminance of 450 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 170 hours.

EXAMPLE 12

In this example, an organic electroluminescence device with the single hetero structure was produced using a mixture of the aminostyryl compound represented by the following structural formula (21)-2 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-2:

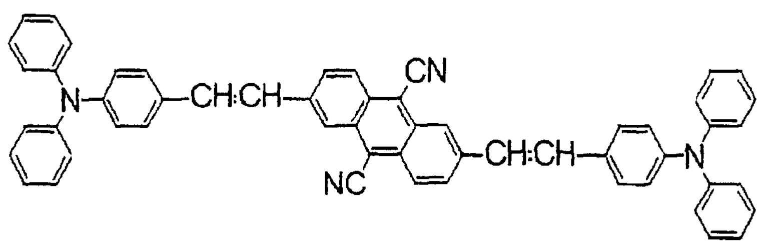

(21)-2

Thus-produced organic electroluminescence device of EXAMPLE 12 was evaluated for light emitting property by applying a forward bias voltage direct current under vacuum atmosphere. The emitted light was red. As a result of the same spectrometry as in EXAMPLE 1, there was obtained a spectrum having a light emitting peak at near 720 nm. A voltage-luminance measurement was made to provide the luminance of 300 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 220 hours.

EXAMPLE 13

In this example, an organic electroluminescence device with the single hetero structure was produced using a mixture of the aminostyryl compound represented by the following structural formula (21)-3 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-3:

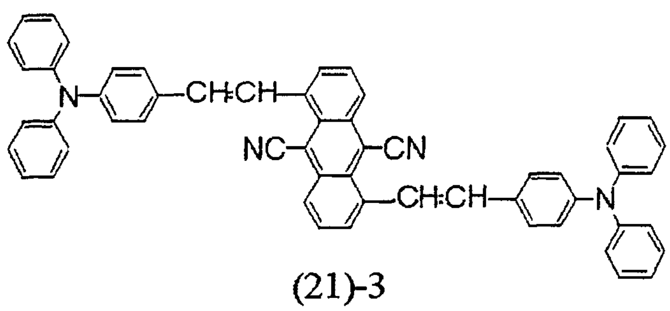

(21)-3

Thus-produced organic electroluminescence device of EXAMPLE 13 was evaluated for light emitting property by applying a forward bias voltage direct current under vacuum atmosphere. The emitted light was red. As a result of the same spectrometry as in EXAMPLE 1, there was obtained a spectrum having a light emitting peak at near 660 nm. A voltage-luminance measurement was made to provide the luminance of 500 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time

for decreasing the luminance to half was 300 hours.

EXAMPLE 14

In this example, an organic electroluminescence device with the single hetero structure was produced using a mixture of the aminostyryl compound represented by the following structural formula (21)-4 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-4:

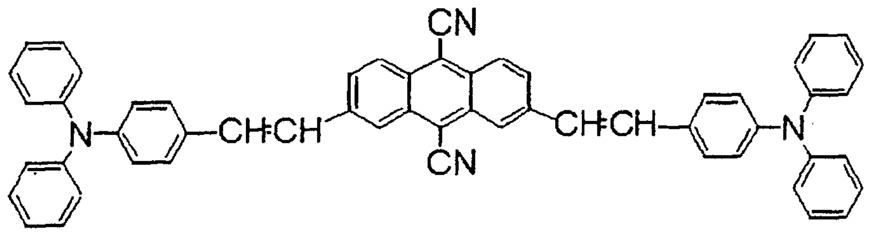

(21)-4

Thus-produced organic electroluminescence device of EXAMPLE 14 was evaluated for light emitting property by applying a forward bias voltage direct current under vacuum atmosphere. The emitted light was red. As a result of the same spectrometry as in EXAMPLE 1, there was obtained a spectrum having a light emitting peak at near 650 nm. A voltage-luminance measurement was made to provide the luminance of 850 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 200 hours.

EXAMPLE 15

In this example, an organic electroluminescence device with the single hetero structure was produced using a mixture of the aminostyryl compound represented by the following structural formula (21)-5 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-5:

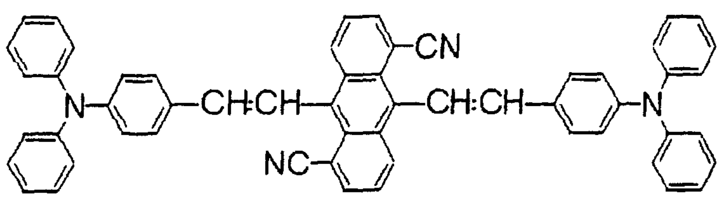

(21)-5

Thus-produced organic electroluminescence device of EXAMPLE 15 was evaluated for light emitting property by applying a forward bias voltage direct current under vacuum atmosphere. The emitted light was red. As a result of the same spectrometry as in EXAMPLE 1, there was obtained a spectrum having a light emitting peak at near 630 nm. A voltage-luminance measurement was made to provide the luminance of 750 cd/$m^2$ at 8V.

After the organic electroluminescence device was produced, it was allowed to stand for one month under nitrogen atmosphere. No device degradation was observed. The organic electroluminescence device was electrified

with a uniform current value at initial luminance of 100 cd/$m^2$ to emit light continuously, and forced deterioration. A time for decreasing the luminance to half was 300 hours.

EXAMPLE 16

In this example, an organic electroluminescence device with the single hetero structure was produced using a mixture of the aminostyryl compound represented by the following structural formula (21)-6 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-6:

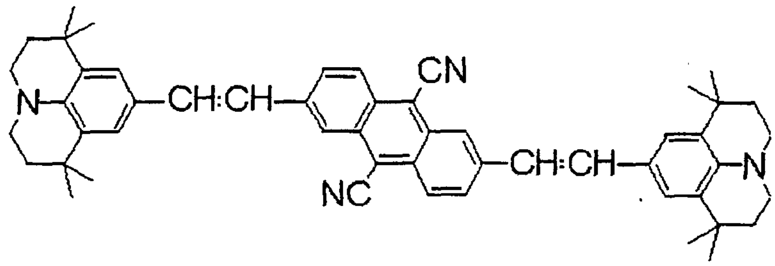

(21)-6

Thus-produced organic electroluminescence device of EXAMPLE 16 was evaluated for light emitting property by applying a forward bias voltage direct current under vacuum atmosphere. The emitted light was red. As a result of the same spectrometry as in EXAMPLE 1, there was obtained a spectrum having a light emitting peak at near 700 nm. A voltage-luminance measurement was made to provide the luminance of 250 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 200 hours.

EXAMPLE 17

In this example, an organic electroluminescence device with the single hetero structure was produced using a mixture of the aminostyryl compound represented by the following structural formula (21)-7 among the aminostyryl compounds represented by the general formula [I], and $Alq_3$ using as the electron transport light emitting layer. The organic electroluminescence device was produced in accordance with the layer structure and the film forming method in EXAMPLE 2.
Structural formula (21)-7:

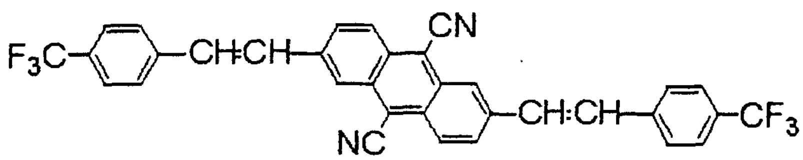

(21)-7

Thus-produced organic electroluminescence device of EXAMPLE 17 was evaluated for light emitting property by applying a forward bias voltage direct current under vacuum atmosphere. The emitted light was red. As a result of

the same spectrometry as in EXMPLE 1, there was obtained a spectrum having a light emitting peak at near 665 nm. A voltage-luminance measurement was made to provide the luminance of 800 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 450 hours.

EXAMPLE 18

In this example, an organic electroluminescence device with the single hetero structure was produced using a mixture of the aminostyryl compound represented by the following structural formula (21)-8 among the aminostyryl compounds represented by the general formula [II], and $Alq_3$ using as the electron transport light emitting layer. The organic electroluminescence device was produced in accordance with the layer structure and the film forming method in EXAMPLE 2.

Structural formula (21)-8:

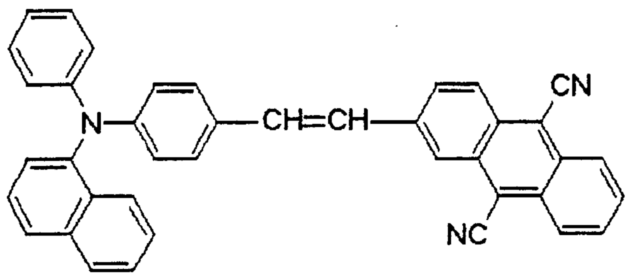

(21)-8

Thus-produced organic electroluminescence device of EXAMPLE 18 was evaluated for light emitting property by applying a forward bias voltage direct current under vacuum atmosphere. The emitted light was red. As a result of the same spectrometry as in EXAMPLE 1, there was obtained a spectrum having a light emitting peak at near 690 nm. A voltage-luminance measurement was made to provide the luminance of 700 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 500 hours.

EXAMPLE 19

In this example, an organic electroluminescence device with the single hetero structure was produced using a mixture of the aminostyryl compound represented by the following structural formula (21)-9 among the aminostyryl compounds represented by the general formula [II], and $Alq_3$ using as the electron transport light emitting layer. The organic electroluminescence device was produced in accordance with the layer structure and the film forming method in EXAMPLE 2.

Structural formula (21)-9:

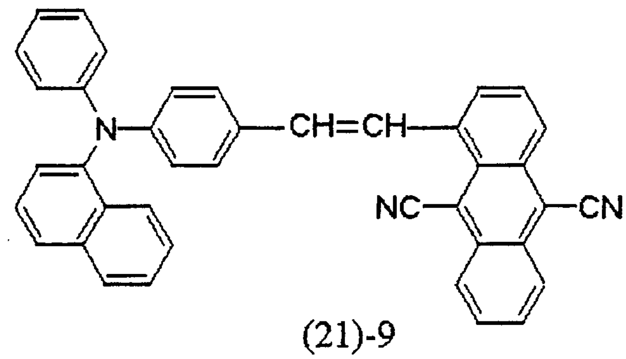

(21)-9

Thus-produced organic electroluminescence device of EXAMPLE 19 was evaluated for light emitting property by applying a forward bias voltage direct current under vacuum atmosphere. The emitted light was red. As a result of the same spectrometry as in EXAMPLE 1, there was obtained a spectrum having a light emitting peak at near 660 nm. A voltage-luminance measurement was made to provide the luminance of 500 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 450 hours.

EXAMPLE 20

In this example, an organic electroluminescence device with the single hetero structure was produced using a mixture of the aminostyryl compound represented by the following structural formula (21)-10 among the aminostyryl compounds represented by the general formula [II], and $Alq_3$ using as the electron transport light emitting layer. The organic electroluminescence device was produced in accordance with the layer structure and the film forming method in EXAMPLE 2.
Structural formula (21)-2:

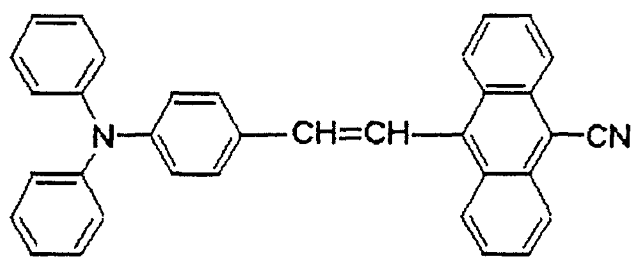

(21)-10

Thus-produced organic electroluminescence device of EXAMPLE 20 was evaluated for light emitting property by applying a forward bias voltage direct current under vacuum atmosphere. The emitted light was orange. As a result of the same spectrometry as in EXAMPLE 1, there was obtained a spectrum having a light emitting peak at near 610 nm. A voltage-luminance measurement was made to provide the luminance of 750 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 500 hours.

EXAMPLE 21

In this example, an organic electroluminescence device with the single hetero structure was produced using

a mixture of the aminostyryl compound represented by the following structural formula (21)-11 among the aminostyryl compounds represented by the general formula [II], and $Alq_3$ using as the electron transport light emitting layer. The organic electroluminescence device was produced in accordance with the layer structure and the film forming method in EXAMPLE 2.

Structural formula (21)-11:

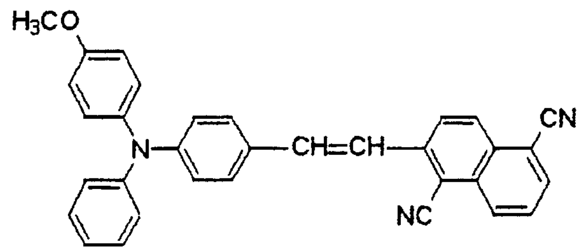

(21)-11

Thus-produced organic electroluminescence device of EXAMPLE 21 was evaluated for light emitting property by applying a forward bias voltage direct current under vacuum atmosphere. The emitted light was orange. As a result of the same spectrometry as in EXAMPLE 1, there was obtained a spectrum having a light emitting peak at near 620 nm. A voltage-luminance measurement was made to provide the luminance of 1200 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 660 hours.

EXAMPLE 22

In this example, an organic electroluminescence device with the single hetero structure was produced using a mixture of the aminostyryl compound represented by the following structural formula (21)-13 among the aminostyryl compounds represented by the general formula [II], and $Alq_3$ using as the electron transport light emitting layer. The organic electroluminescence device was produced in accordance with the layer structure and the film forming method in EXAMPLE 2.

Structural formula (21)-13:

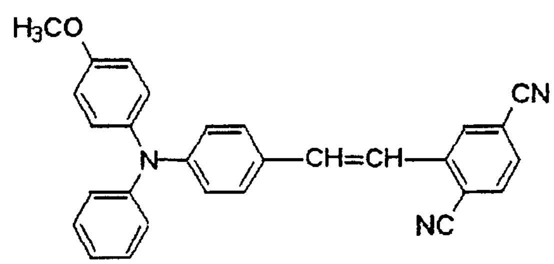

(21)-13

Thus-produced organic electroluminescence device of EXAMPLE 22 was evaluated for light emitting property by applying a forward bias voltage direct current under vacuum atmosphere. The emitted light was orange. As a result of the same spectrometry as in EXAMPLE 1, there was obtained a spectrum having a light emitting peak at near 590 nm. A voltage-luminance measurement was made to provide the luminance of 1500 cd/$m^2$ at 8V.

After the organic electroluminescence device was produced, it was allowed to stand for one month under nitrogen atmosphere. No device degradation was observed. The organic electroluminescence device was electrified

with a uniform current value at initial luminance of 100 cd/$m^2$ to emit light continuously, and forced deterioration. A time for decreasing the luminance to half was 500 hours.

EXAMPLE 23

In this example, an organic electroluminescence device with the single hetero structure was produced using a mixture of the aminostyryl compound represented by the following structural formula (21)-14 among the aminostyryl compounds represented by the general formula [II], and $Alq_3$ using as the electron transport light emitting layer. The organic electroluminescence device was produced in accordance with the layer structure and the film forming method in EXAMPLE 2.
Structural formula (21)-14:

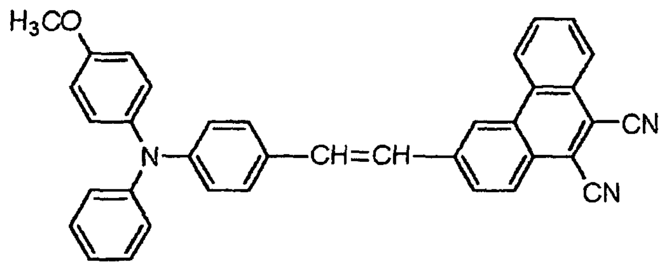

(21)-14

Thus-produced organic electroluminescence device of EXAMPLE 23 was evaluated for light emitting property by applying a forward bias voltage direct current under vacuum atmosphere. The emitted light was red. As a result of the same spectrometry as in EXAMPLE 1, there was obtained a spectrum having a light emitting peak at near 630 nm. A voltage-luminance measurement was made to provide the luminance of 1100 cd/$m^2$ at 8V.
After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 500 hours.

EXAMPLE 24

In this example, an organic electroluminescence device with the single hetero structure was produced using a mixture of the aminostyryl compound represented by the following structural formula (21)-15 among the aminostyryl compounds represented by the general formula [II], and $Alq_3$ using as the electron transport light emitting layer. The organic electroluminescence device was produced in accordance with the layer structure and the film forming method in EXAMPLE 2.
Structural formula (21)-15:

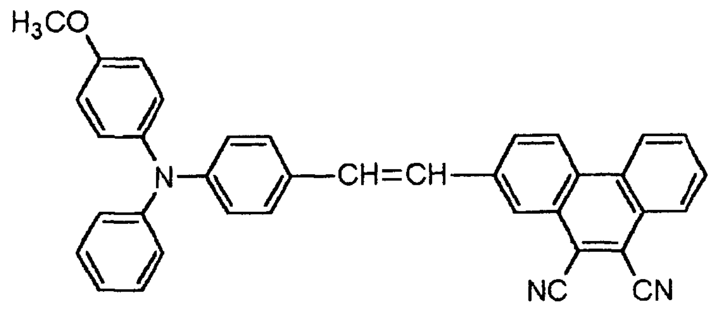

(21)-15

Thus-produced organic electroluminescence device of EXAMPLE 24 was evaluated for light emitting property by applying a forward bias voltage direct current under vacuum atmosphere. The emitted light was red. As a result of the same spectrometry as in EXAMPLE 1, there was obtained a spectrum having a light emitting peak at near 630 nm. A voltage-luminance measurement was made to provide the luminance of 700 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 600 hours.

EXAMPLE 25

In this example, an organic electroluminescence device with the single hetero structure was produced using a mixture of the aminostyryl compound represented by the following structural formula (21)-18 among the aminostyryl compounds represented by the general formula [II], and $Alq_3$ using as the electron transport light emitting layer. The organic electroluminescence device was produced in accordance with the layer structure and the film forming method in EXAMPLE 2.
Structural formula (21)-18:

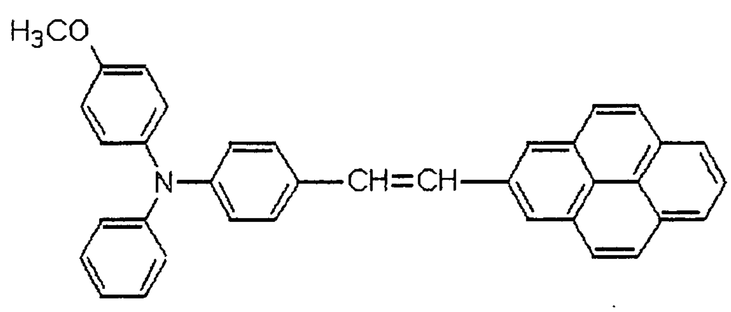

(21)-18

Thus-produced organic electroluminescence device of EXAMPLE 25 was evaluated for light emitting property by applying a forward bias voltage direct current under vacuum atmosphere. The emitted light was orange. As a result of the same spectrometry as in EXAMPLE 1, there was obtained a spectrum having a light emitting peak at near 580 nm. A voltage-luminance measurement was made to provide the luminance of 900 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 450 hours.

EXAMPLE 26

In this example, an organic electroluminescence device shown in Fig. 7 was produced using a mixture of the aminostyryl compound represented by the above structural formula (21)-1 among the aminostyryl compounds represented by the general formula [I], and the above structural formula α-NPD (α-naphthyl phenyl diamine) using as the positive hole transport light emitting layer.

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer (that also acted as a light emitting layer), for example, with a thickness of 50 nm was formed using the above structural formula (21)-1 and the α-NPD that was a material for the hole transport layer at a weight ratio of 1:1 under a vacuum of $10^{-4}$ Pa or less by a vapor deposition method. Respective vapor deposition rates were 0.1 nm/sec.

As a material for a hole blocking layer, bathocuproin having the following structural formula was vapor deposited on the positive hole transport layer. The hole blocking layer consisting of the bathocuproin had, for example, a thickness of 15 nm, and a vapor deposition rate was 0.1 nm/sec.

Further, as a material for an electron transport layer, $Alq^3$ (tris(8-quinolinol)aluminum) having the above structural formula was vapor deposited on the positive hole transport layer. The electron transport layer consisting of the $Alq^3$ had, for example, a thickness of 50 nm, and a vapor deposition rate was 0.2 nm/sec.
Bathocuproin:

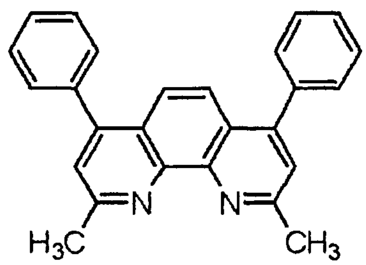

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 26, the organic electroluminescence device as shown in Fig. 7 was produced.

Thus-produced organic electroluminescence device of EXAMPLE 26 was evaluated for light emitting property by applying a forward bias voltage direct current under vacuum atmosphere. The emitted light was red. As a result of the spectrometry, there was obtained a spectrum having a light emitting peak at near 720 nm. In the spectrometry, a spectrometer that used a photo diode array manufactured by Otsuka Denshi KK as a detector was used. A voltage-luminance measurement was made to provide the luminance of 250 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 50 cd/$m^2$ to emit light continuously, and forced deterioration. A time for decreasing the luminance to half was 200 hours.

EXAMPLE 27

In this example, an organic electroluminescence device shown in Fig. 8 was produced using a mixture of the aminostyryl compound represented by the above structural formula (21)-1 among the aminostyryl compounds represented by the general formula [I], and the above structural formula α-NPD (α-naphthyl phenyl diamine) using as the electron transport light emitting layer.

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer, for example, with a thickness of 30 nm was formed using the α-NPD under a vacuum of $10^{-4}$ Pa or less by a vapor deposition method. A vapor deposition rate was 0.2 nm/sec.

As a light emitting material, the aminostyryl compound represented by the above structural formula (21)-1 and the $Alq^3$ that was an electron transport material were vapor deposited at a weight ratio of 1:1 on the positive hole transport layer. The light emitting layer consisting of the aminostyryl compound represented by the above structural

formula (21)-1 and the $Alq^3$ had, for example, a thickness of 30 nm, and respective vapor deposition rates were 0.2 nm/sec.

As a material for a hole blocking layer, the bathocuproin having the above structural formula was vapor deposited on the positive hole transport layer. The hole blocking layer consisting of the bathocuproin had, for example, a thickness of 15 nm, and a vapor deposition rate was 0.1 nm/sec.

Further, as a material for an electron transport layer, the $Alq^3$ having the above structural formula was vapor deposited on the positive hole transport layer. The electron transport layer consisting of the $Alq^3$ had, for example, a thickness of 30 nm, and a vapor deposition rate was 0.2 nm/sec.

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 27, the organic electroluminescence device as shown in Fig. 8 was produced.

Thus-produced organic electroluminescence device of EXAMPLE 27 was evaluated for light emitting property by applying a forward bias voltage direct current under vacuum atmosphere. The emitted light was red. As a result of the same spectrometry as in EXAMPLE 26, there was obtained a spectrum having a light emitting peak at near 720 nm. A voltage-luminance measurement was made to provide the luminance of 220 $cd/m^2$ at 8V.

After the organic electroluminescence device was produced, it was allowed to stand for one month under nitrogen atmosphere. No device degradation was observed. The organic electroluminescence device was electrified with a uniform current value at initial luminance of 50 $cd/m^2$ to emit light continuously, and forced deterioration. A time for decreasing the luminance to half was 350 hours.

EXAMPLE 28

In this example, an organic electroluminescence device shown in Fig. 8 was produced using a mixture of the aminostyryl compound represented by the above structural formula (21)-8 and the aminostyryl compound represented by the above structural formula (21)-1 among the aminostyryl compounds represented by the general formula [I] or [II] using as the light emitting layer.

A glass substrate with a size of 30 mm x 30 mm including an anode consisting of ITO with a thickness of 100 nm on one surface was set in a vacuum deposition device. As a vapor deposition mask, a metal mask having a plurality of unit openings, each having a size of 2.0 mm x 2.0 mm was disposed adjacent to the substrate. A positive hole transport layer, for example, with a thickness of 30 nm was formed using the $\alpha$-NPD under a vacuum of $10^{-4}$ Pa or less by a vapor deposition method. A vapor deposition rate was 0.2 nm/sec.

As a light emitting material, the aminostyryl compound represented by the above structural formula (21)-8 and the aminostyryl compound represented by the above structural formula (21)-1 were vapor deposited at a weight ratio of 1:3 on the positive hole transport layer. The light emitting layer consisting of the aminostyryl compound represented by the aminostyryl compound represented by the above structural formula (21)-8 and the aminostyryl compound represented by the above structural formula (21)-1 had, for example, a thickness of 30 nm. A vapor deposition rate of the compound represented by the above structural formula (21)-8 was 0.1 nm/sec, and a vapor deposition rate of the compound represented by the above structural formula (21)-1 was 0.3 nm/sec.

As a material for a hole blocking layer, the bathocuproin having the above structural formula was vapor deposited on the positive hole transport layer. The hole blocking layer consisting of the bathocuproin had, for example, a thickness of 15 nm, and a vapor deposition rate was 0.1 nm/sec.

Further, as a material for an electron transport layer, the $Alq^3$ having the above structural formula was vapor deposited on the positive hole transport layer. The electron transport layer consisting of the $Alq^3$ had, for example, a thickness of 30 nm, and a vapor deposition rate was 0.2 nm/sec.

As an anode material, a laminated film of Mg and Ag was used. The laminated film with thicknesses of, for example, 50 nm (Mg film) and 150 nm (Ag film) was formed by vapor deposition at a vapor deposition rate of 1 nm/sec. According to EXAMPLE 28, the organic electroluminescence device as shown in Fig. 8 was produced.

Thus-produced organic electroluminescence device of EXAMPLE 28 was evaluated for light emitting property by applying a forward bias voltage direct current under vacuum atmosphere. The emitted light was red. As a result of the same spectrometry as in EXAMPLE 26, there was obtained a spectrum having a light emitting peak at near 710 nm. A voltage-luminance measurement was made to provide the luminance of 250 $cd/m^2$ at 8V.

After the organic electroluminescence device was produced, it was allowed to stand for one month under nitrogen atmosphere. No device degradation was observed. The organic electroluminescence device was electrified with a uniform current value at initial luminance of 50 $cd/m^2$ to emit light continuously, and forced deterioration. A time for decreasing the luminance to half was 330 hours.

EXAMPLE 29

In this example, an organic electroluminescence device was produced using a mixture (weight ratio 1:3) of the aminostyryl compound represented by the above structural formula (21)-9 and the aminostyryl compound represented by the above structural formula (21)-2 among the aminostyryl compounds represented by the general formula [I] or [II], using as the electron transport light emitting layer. The organic electroluminescence device was produced in accordance with the layer structure and the film forming method in EXAMPLE 28.

Thus-produced organic electroluminescence device of EXAMPLE 29 was evaluated for light emitting property by applying a forward bias voltage direct current under vacuum atmosphere. The emitted light was red. As a result of the same spectrometry as in EXAMPLE 26, there was obtained a spectrum having a light emitting peak at near 750 nm. A voltage-luminance measurement was made to provide the luminance of 15 $cd/m^2$ at 8V.

After the organic electroluminescence device was produced, it was allowed to stand for one month under nitrogen atmosphere. No device degradation was observed. The organic electroluminescence device was electrified with a uniform current value at initial luminance of 20 $cd/m^2$ to emit light continuously, and forced deterioration. A time for decreasing the luminance to half was 150 hours.

EXAMPLE 30

In this example, an organic electroluminescence device was produced using a mixture (weight ratio 1:3) of the aminostyryl compound represented by the above structural formula (21)-10 and the aminostyryl compound represented by the above structural formula (21)-3 among the aminostyryl compounds represented by the general formula [I] or [II], using as the electron transport light emitting layer. The organic electroluminescence device was produced in accordance with the layer structure and the film forming method in EXAMPLE 28.

Thus-produced organic electroluminescence device of EXAMPLE 30 was evaluated for light emitting property by applying a forward bias voltage direct current under vacuum atmosphere. The emitted light was orange. As a result of the same spectrometry as in EXAMPLE 26, there was obtained a spectrum having a light emitting peak at near 620 nm. A voltage-luminance measurement was made to provide the luminance of 450 $cd/m^2$ at 8V.

After the organic electroluminescence device was produced, it was allowed to stand for one month under nitrogen atmosphere. No device degradation was observed. The organic electroluminescence device was electrified with a uniform current value at initial luminance of 100 $cd/m^2$ to emit light continuously, and forced deterioration. A time for decreasing the luminance to half was 350 hours.

EXAMPLE 31

In this example, an organic electroluminescence device was produced using a mixture (weight ratio 1:3) of the aminostyryl compound represented by the above structural formula (21)-11 and the aminostyryl compound represented by the above structural formula (21)-4 among the aminostyryl compounds represented by the general formula [I] or [II], using as the electron transport light emitting layer. The organic electroluminescence device was produced in accordance with the layer structure and the film forming method in EXAMPLE 28.

Thus-produced organic electroluminescence device of EXAMPLE 31 was evaluated for light emitting property by applying a forward bias voltage direct current under vacuum atmosphere. The emitted light was red. As a result of the same spectrometry as in EXAMPLE 26, there was obtained a spectrum having a light emitting peak at near 660 nm. A voltage-luminance measurement was made to provide the luminance of 200 $cd/m^2$ at 8V.

After the organic electroluminescence device was produced, it was allowed to stand for one month under nitrogen atmosphere. No device degradation was observed. The organic electroluminescence device was electrified with a uniform current value at initial luminance of 100 $cd/m^2$ to emit light continuously, and forced deterioration. A time for decreasing the luminance to half was 150 hours.

EXAMPLE 32

In this example, an organic electroluminescence device was produced using a mixture (weight ratio 1:3) of the aminostyryl compound represented by the above structural formula (21)-13 and the aminostyryl compound represented by the above structural formula (21)-5 among the aminostyryl compounds represented by the general formula [I] or [II], using as the electron transport light emitting layer. The organic electroluminescence device was produced in accordance with the layer structure and the film forming method in EXAMPLE 28.

Thus-produced organic electroluminescence device of EXAMPLE 32 was evaluated for light emitting property by applying a forward bias voltage direct current under vacuum atmosphere. The emitted light was orange. As a result of the same spectrometry as in EXAMPLE 26, there was obtained a spectrum having a light emitting peak at near 615

nm. A voltage-luminance measurement was made to provide the luminance of 280 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 250 hours.

EXAMPLE 33

In this example, an organic electroluminescence device was produced using a mixture (weight ratio 1:3) of the aminostyryl compound represented by the above structural formula (21)-14 and the aminostyryl compound represented by the above structural formula (21)-6 among the aminostyryl compounds represented by the general formula [I] or [II], using as the electron transport light emitting layer. The organic electroluminescence device was produced in accordance with the layer structure and the film forming method in EXAMPLE 28.

Thus-produced organic electroluminescence device of EXAMPLE 33 was evaluated for light emitting property by applying a forward bias voltage direct current under vacuum atmosphere. The emitted light was red. As a result of the same spectrometry as in EXAMPLE 26, there was obtained a spectrum having a light emitting peak at near 670 nm. A voltage-luminance measurement was made to provide the luminance of 210 cd/$m^2$ at 8V.

After the organic electroluminescence device was produced, it was allowed to stand for one month under nitrogen atmosphere. No device degradation was observed. The organic electroluminescence device was electrified with a uniform current value at initial luminance of 100 cd/$m^2$ to emit light continuously, and forced deterioration. A time for decreasing the luminance to half was 220 hours.

According to the organic electroluminescence device of the present invention, in the organic electroluminescence device comprising an organic layer having a light emitting area between an anode and a cathode, at least a part of the organic layer consists of a mixture containing at least one of the aminostyryl compound represented by the above general formula [I] or [II], whereby it is possible to provide the organic electroluminescence device emitting a stable red or red-like light with high luminance.

## Claims

1. An organic electroluminescence device comprising an organic layer having a light emitting area between an anode and a cathode, wherein at least a part of the organic layer consists of at least one of an aminostyryl compound represented by the following general formula [I] or [II],

General formula [I]:

$$Y^1\text{-CH=CH-}X^1\text{-CH=CH-}Y^2$$

General formula [II]:

$$Y^3\text{-CH=CH-}X^2$$

[wherein in the general formula [I], $X^1$ is a group represented by any of the following general formulas (1) to (4),

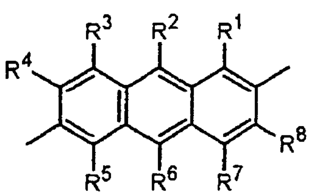

(1)

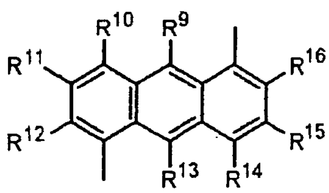

(2)

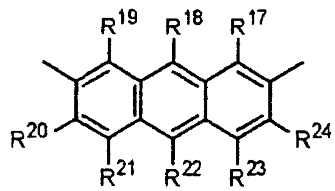

(3)

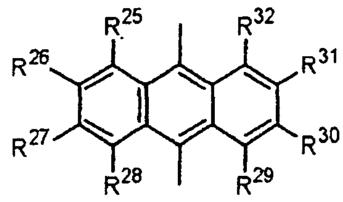

(4)

(wherein in each of $R^1$ to $R^8$, $R^9$ to $R^{16}$, $R^{17}$ to $R^{24}$, and $R^{25}$ to $R^{32}$ in the general formulas (1) to (4), at least one is a group selected from a halogen atom, a nitro group, a cyano group, a trifluoromethyl group, and the others are groups selected from a hydrogen atom, an alkyl group, an aryl group, an alkoxyl group, a halogen atom, a nitro group, a cyano group, and a trifluoromethyl group, which may be the same or different),
wherein in the general formula [II], $X^2$ is a group represented by any of the following general formulas (5) to (17),

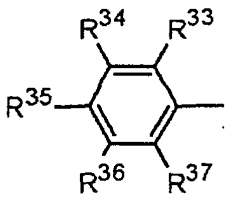

(5)

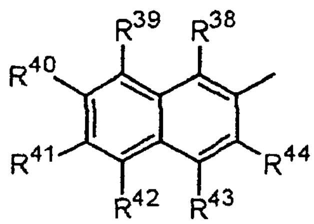

(6)

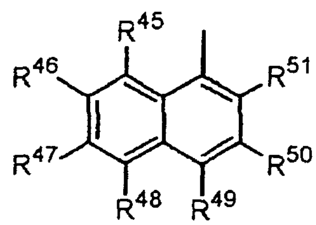

(7)

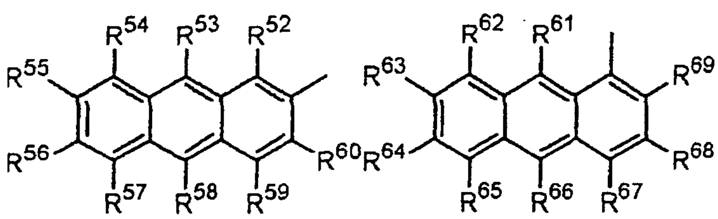

(8)

(9)

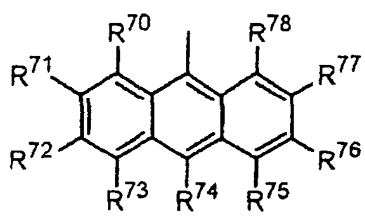

(10)

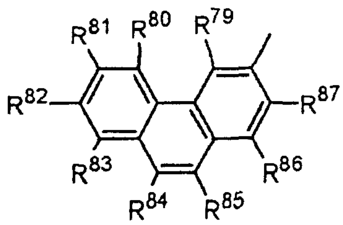

(11)

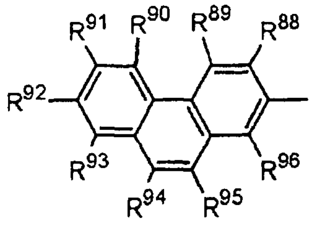

(12)

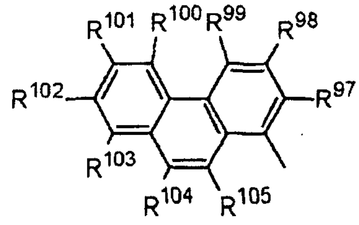

(13)

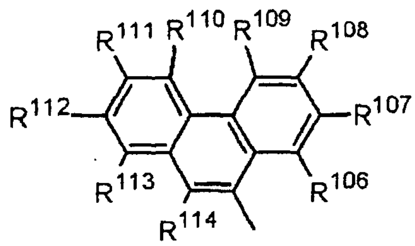

(14)

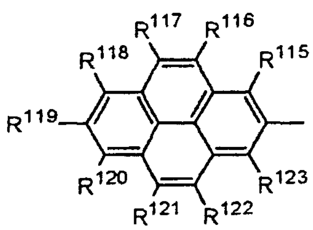

(15)

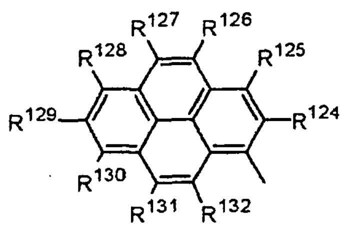

(16)

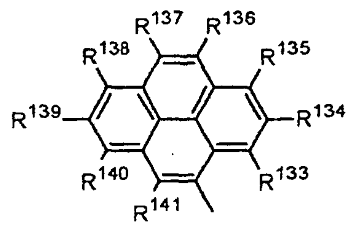

(17)

(wherein in the general formulas (5) to (17), $R^{33}$ to $R^{141}$ are groups selected from a hydrogen atom, a halogen atom, a nitro group, a cyano group, and a trifluoromethyl group, which may be the same or different),
wherein in the general formulas [I] and [II], $Y^1$, $Y^2$ and $Y^3$ are groups selected from a hydrogen atom, an alkyl group that may have a substituted group, or an aryl group that may have a substituted group represented by any of the following general formulas (18) to (20), which may be the same or different,

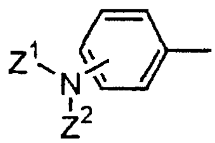

(18)

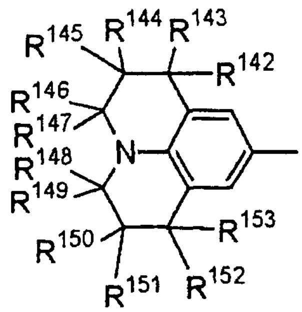

(19)

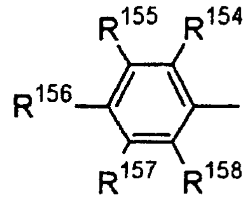

(20)

(wherein in the general formula (18), $Z^1$ and $Z^2$ are groups selected from a hydrogen atom, an alkyl group that may have a substituted group, or an aryl group that may have a substituted group, which may be the same or different, and

wherein in the general formulas (19) and (20), $R^{142}$ to $R^{158}$ are groups selected from a hydrogen atom, an alkyl group that may have a substituted group, an aryl group that may have a substituted group, an alkoxyl group that may have a substituted group, a halogen atom, a nitro group, a cyano group, and a trifluoromethyl group, which may be the same or different)].

**2.** An organic electroluminescence device according to Claim 1, wherein the organic layer has an organic laminated structure having a hole transport layer and an electron transport layer, and wherein at least the electron transport layer of the organic layer is a mixture layer containing at least one aminostyryl compound represented by the general formula [I] or [II].

**3.** An organic electroluminescence device according to Claim 1, wherein the organic layer has an organic laminated structure having a hole transport layer and an electron transport layer, and wherein at least the hole transport layer of the organic layer is a mixture layer containing at least one aminostyryl compound represented by the general formula [I] or [II].

**4.** An organic electroluminescence device according to Claim 1, wherein the organic layer has an organic laminated structure having a hole transport layer and an electron transport layer, wherein the hole transport layer is a mixture layer containing at least one aminostyryl compound represented by the general formula [I] or [II], and wherein the electron transport layer is a mixture layer containing at least one aminostyryl compound represented by the general formula [I] or [II].

**5.** An organic electroluminescence device according to Claim 1, wherein the organic layer has an organic laminated structure having a hole transport layer, a light emitting layer, and an electron transport layer, and wherein at least the light emitting layer of the organic layer is a mixture layer containing at least one aminostyryl compound represented by the general formula [I] or [II].

**6.** An organic electroluminescence device according to Claim 1, wherein the percentage of the aminostyryl compound in the mixture is 10 to 100% by weight.

**7.** An organic electroluminescence device comprising an organic layer having a light emitting area between an anode and a cathode, wherein at least a part of the organic layer consists of a mixture containing at least one aminostyryl compound represented by the following structural formulas (21)-1 to (21)-20:

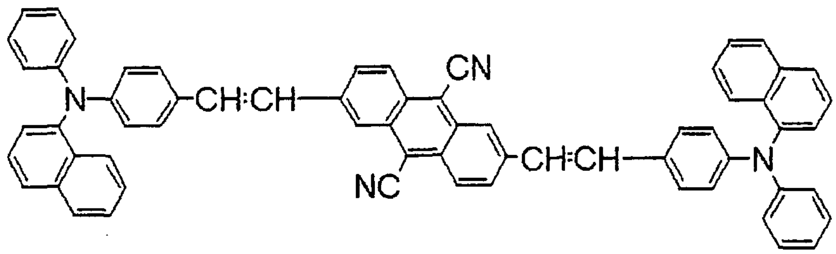

(21)-1

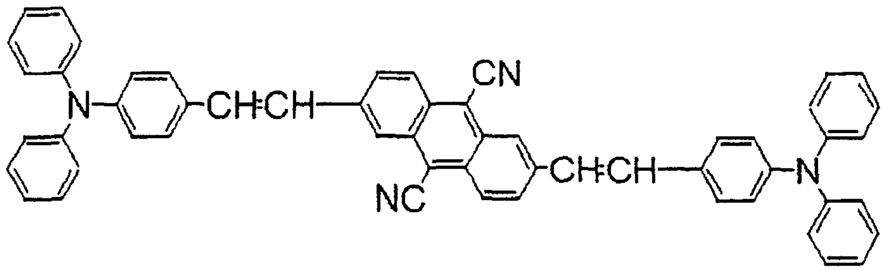

(21)-2

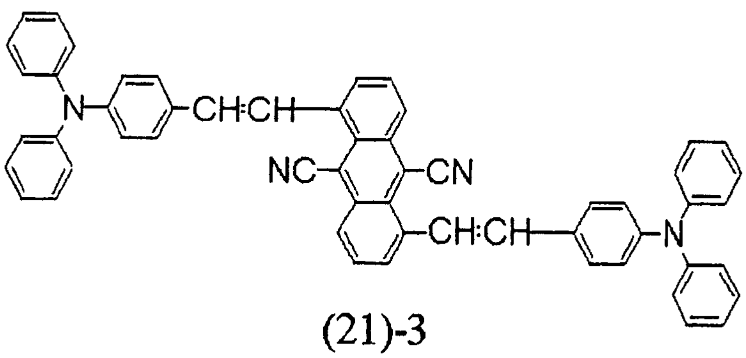

(21)-3

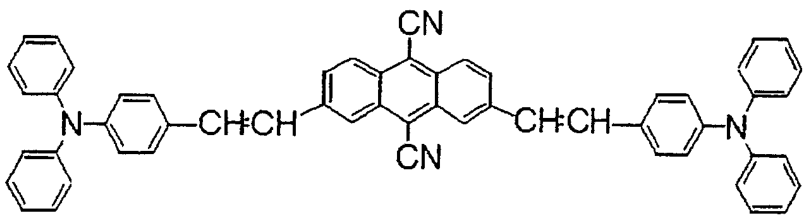

(21)-4

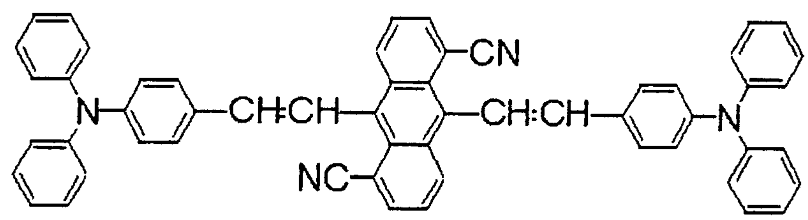

(21)-5

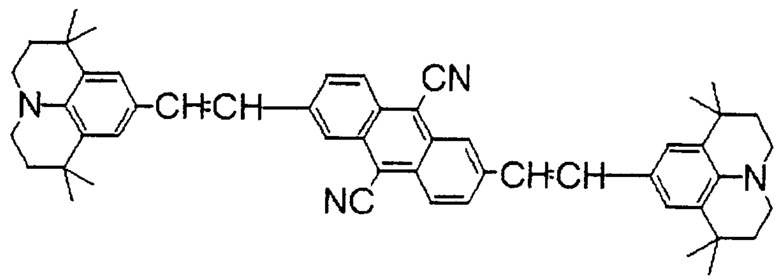

(21)-6

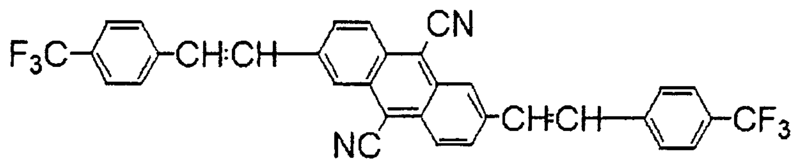

(21)-7

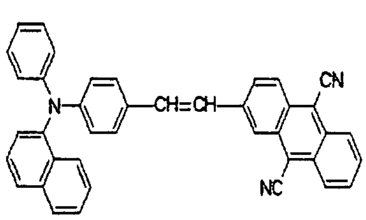

(21)-8

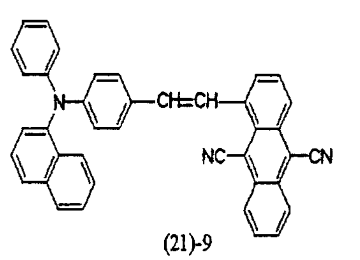

(21)-9

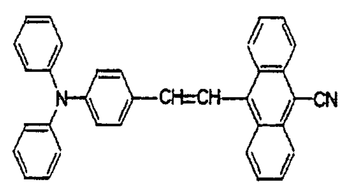

(21)-10

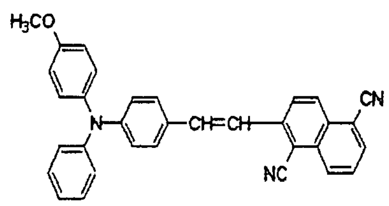

(21)-11

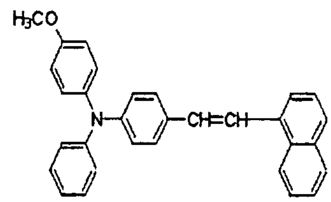

(21)-12

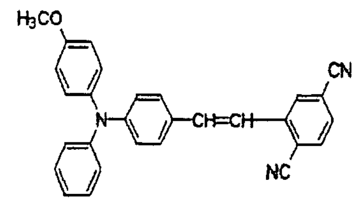

(21)-13

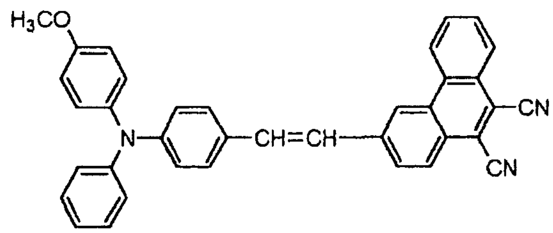

(21)-14

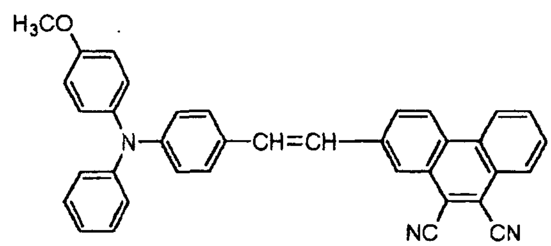

(21)-15

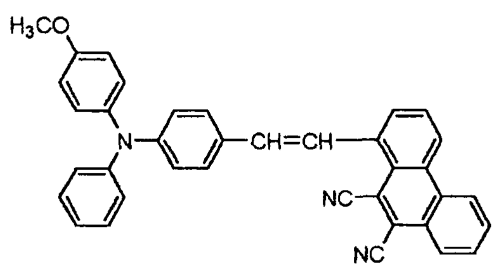

(21)-16

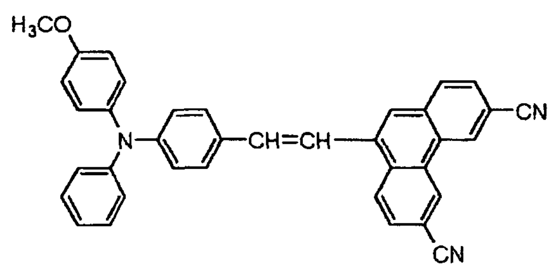

(21)-17

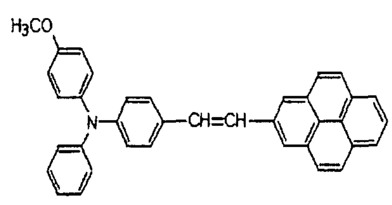

(21)-18

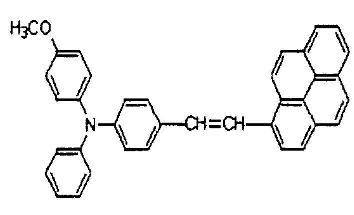

(21)-19

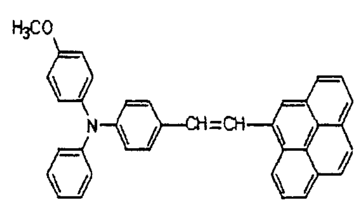

(21)-20

**8.** An organic electroluminescence device according to Claim 7, wherein the organic layer has an organic laminated structure having a hole transport layer and an electron transport layer, and wherein at least the electron transport layer of the organic layer is a mixture layer containing at least one aminostyryl compound represented by the

structural formulas (21)-1 to (21)-20.

**9.** An organic electroluminescence device according to Claim 7, wherein the organic layer has an organic laminated structure having a hole transport layer and an electron transport layer, and wherein at least the hole transport layer of the organic layer is a mixture layer containing at least one aminostyryl compound represented by the structural formulas (21)-1 to (21)-20.

**10.** An organic electroluminescence device according to Claim 7, wherein the organic layer has an organic laminated structure having a hole transport layer and an electron transport layer, wherein the hole transport layer is a mixture layer containing at least one aminostyryl compound represented by the structural formulas (21)-1 to (21)-20, and wherein the electron transport layer is a mixture layer containing at least one aminostyryl compound represented by the structural formulas (21)-1 to (21)-20.

**11.** An organic electroluminescence device according to Claim 7, wherein the organic layer has an organic laminated structure having a hole transport layer, a light emitting layer, and an electron transport layer, and wherein at least the light emitting layer of the organic layer is a mixture layer containing at least one aminostyryl compound represented by the structural formulas (21)-1 to (21)-20.

**12.** An organic electroluminescence device according to Claim 7, wherein the percentage of the aminostyryl compound in the mixture is 10 to 100% by weight.

**13.** An organic electroluminescence device comprising an organic layer having a light emitting area between an anode and a cathode, wherein at least a part of the organic layer consists of a mixture containing at least one aminostyryl compound represented by the following structural formulas (21)-1 to (21)-20, and a red light emitting dye having a light emission maximum within the range of 600 nm to 700 nm,

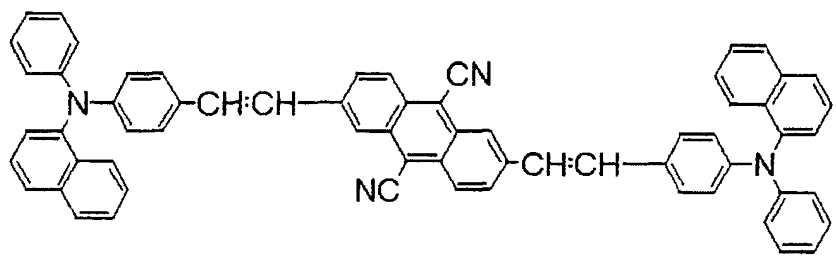

(21)-1

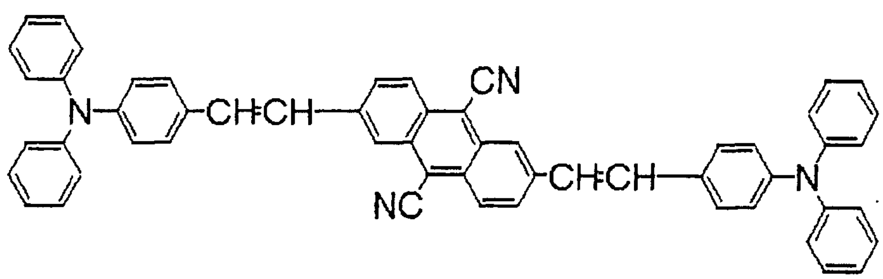

(21)-2

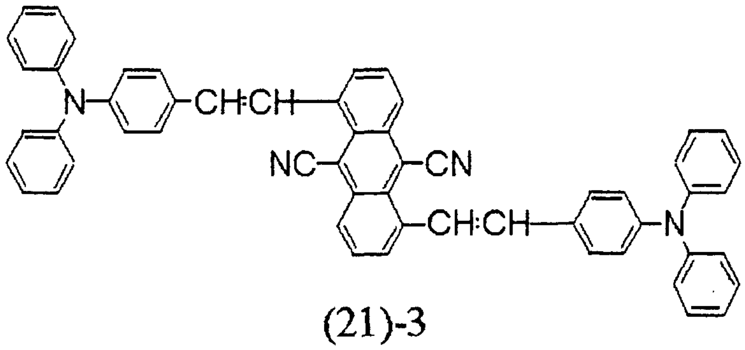

(21)-3

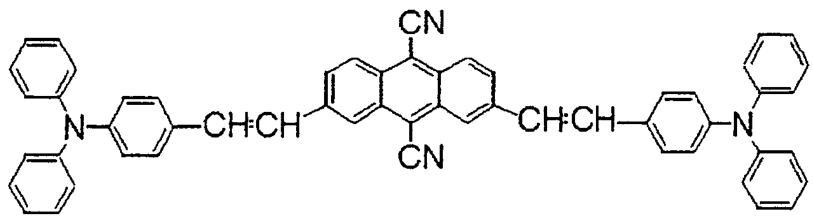

(21)-4

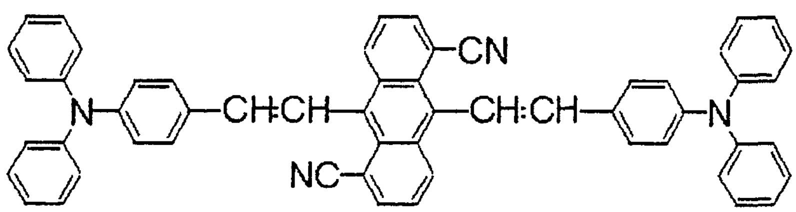

(21)-5

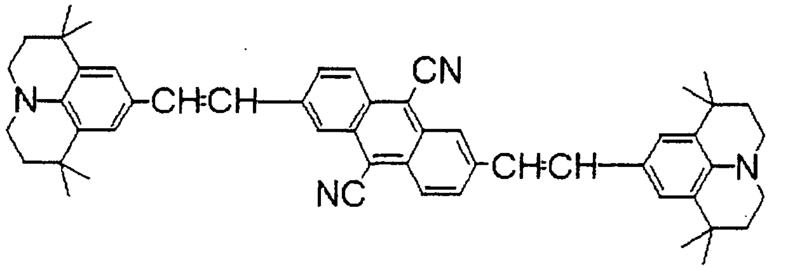

(21)-6

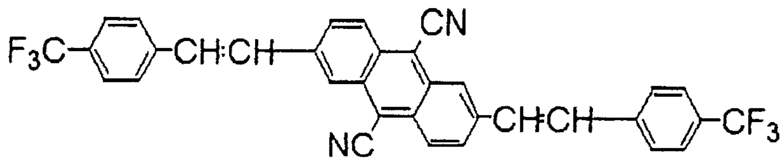

(21)-7

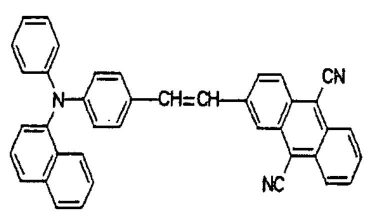

(21)-8

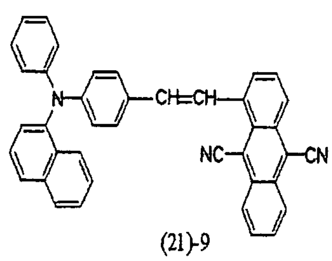

(21)-9

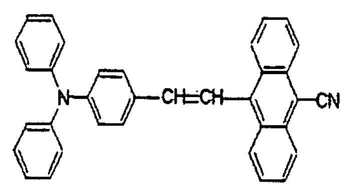

(21)-10

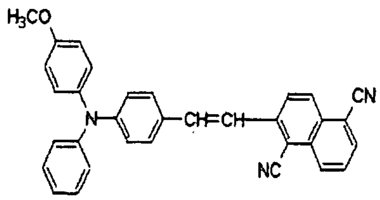

(21)-11

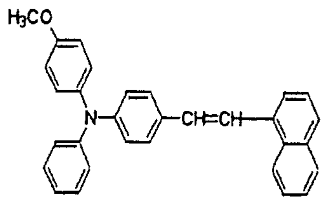

(21)-12

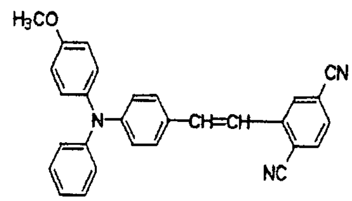

(21)-13

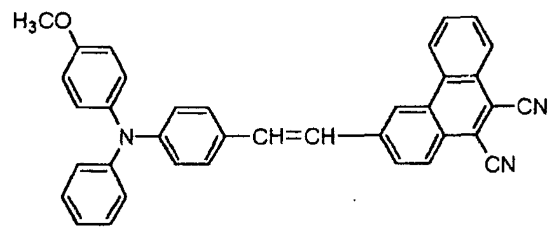

(21)-14

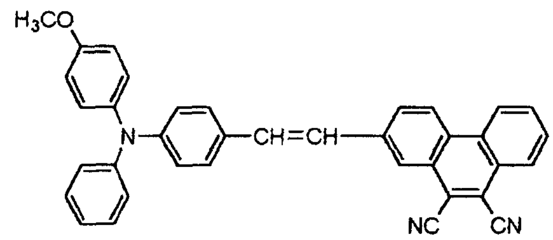

(21)-15

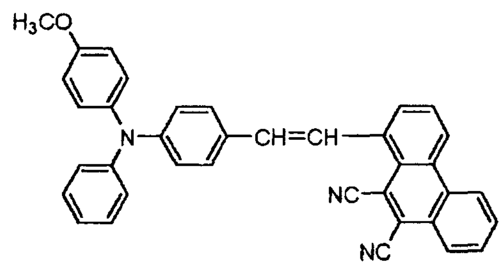

(21)-16

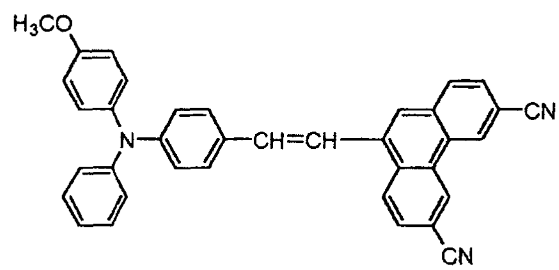

(21)-17

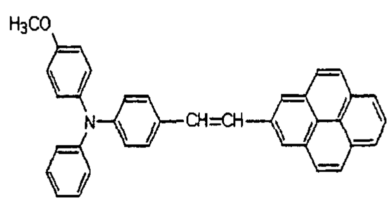

(21)-18

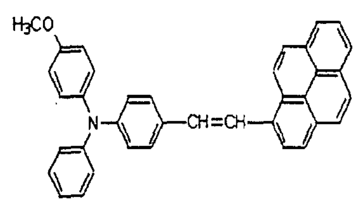

(21)-19

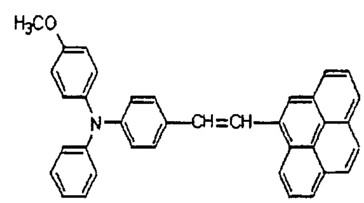

(21)-20

**14.** An organic electroluminescence device according to Claim 13, wherein the organic layer has an organic laminated structure having a hole transport layer and an electron transport layer, and wherein at least the electron transport layer of the organic layer is a mixture layer containing at least one aminostyryl compound represented by the structural formulas (21)-1 to (21)-20.

**15.** An organic electroluminescence device according to Claim 13, wherein the organic layer has an organic laminated structure having a hole transport layer and an electron transport layer, and wherein at least the hole transport layer of the organic layer is a mixture layer containing at least one aminostyryl compound represented by the structural formulas (21)-1 to (21)-20.

**16.** An organic electroluminescence device according to Claim 13, wherein the organic layer has an organic laminated structure having a hole transport layer and an electron transport layer, wherein the hole transport layer is a mixture layer containing at least one aminostyryl compound represented by the structural formulas (21)-1 to (21)-20, and wherein the electron transport layer is a mixture layer containing at least one aminostyryl compound represented by the structural formulas (21)-1 to (21)-20.

**17.** An organic electroluminescence device according to Claim 13, wherein the organic layer has an organic laminated

structure having a hole transport layer, a light emitting layer, and an electron transport layer, and wherein at least the light emitting layer of the organic layer is a mixture layer containing at least one aminostyryl compound represented by the structural formulas (21)-1 to (21)-20.

**18.** An organic electroluminescence device according to Claim 13, wherein the percentage of the aminostyryl compound in the mixture is 10 to 100% by weight.

**19.** An organic electroluminescence device comprising an organic layer having a light emitting area between an anode and a cathode, wherein at least a part of the organic layer consists of a mixture containing at least one aminostyryl compound represented by the following general formula [I] or [II], and wherein a hole blocking layer is disposed on the cathode side of the layer comprising the mixture,

General formula [I]:

$$Y^1\text{-CH=CH-}X^1\text{-CH=CH-}Y^2$$

General formula [II]:

$$Y^3\text{-CH=CH-}X^2$$

[wherein in the general formula [I], $X^1$ is a group represented by any of the following general formulas (1) to (4) ,

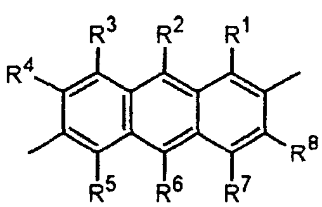

(1)

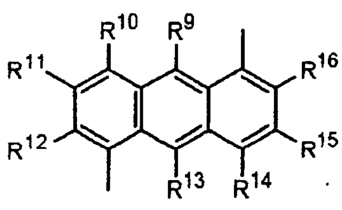

(2)

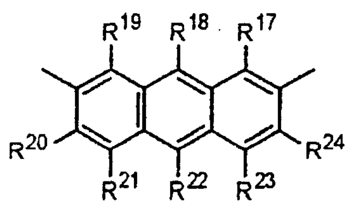

(3)

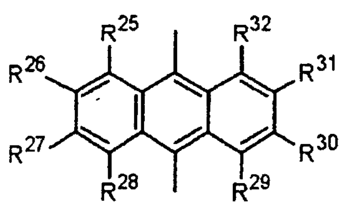

(4)

(wherein in each of $R^1$ to $R^8$, $R^9$ to $R^{16}$, $R^{17}$ to $R^{24}$, and $R^{25}$ to $R^{32}$ in the general formulas (1) to (4), at least one is a group selected from a halogen atom, a nitro group, a cyano group, a trifluoromethyl group, and the others are groups selected from a hydrogen atom, an alkyl group, an aryl group, an alkoxyl group, a halogen atom, a nitro group, a cyano group, and a trifluoromethyl group, which may be the same or different) ,
wherein in the general formula [II], $X^2$ is a group represented by any of the following general formulas (5) to (17),

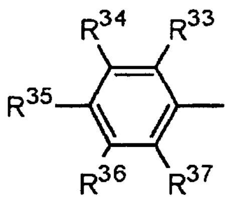
(5)

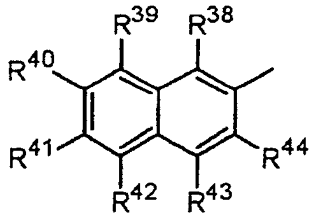
(6)

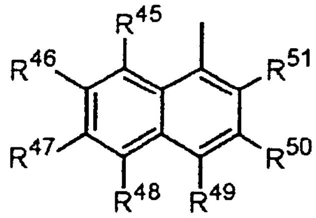
(7)

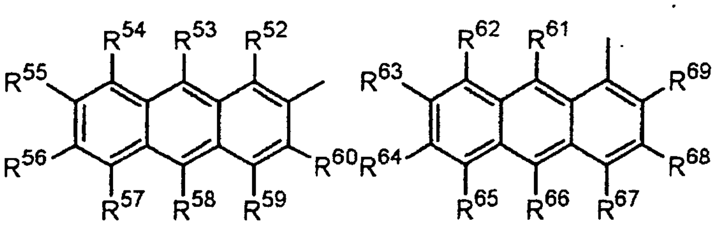
(8)

(9)

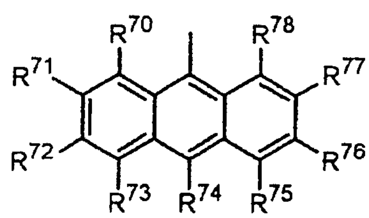
(10)

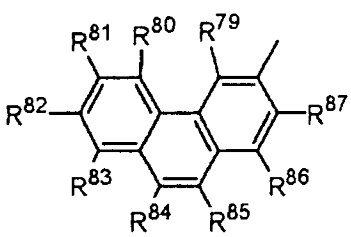
(11)

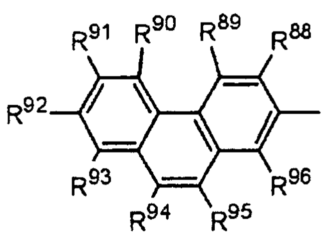
(12)

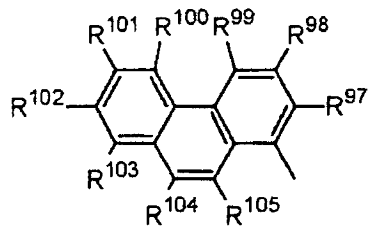
(13)

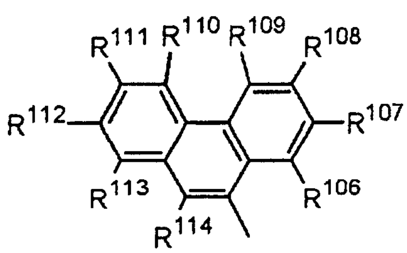
(14)

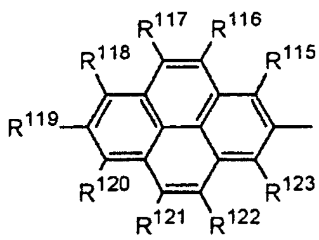

(15)

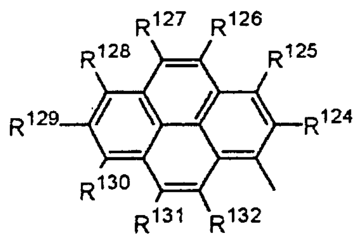

(16)

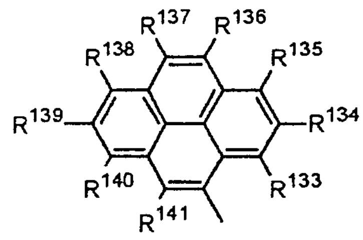

(17)

(wherein in the general formulas (5) to (17), $R^{33}$ to $R^{141}$ are groups selected from a hydrogen atom, a halogen atom, a nitro group, a cyano group, and a trifluoromethyl group, which may be the same or different), wherein in the general formulas [I] and [II], $Y^1$, $Y^2$ and $Y^3$ are groups selected from a hydrogen atom, an alkyl group that may have a substituted group, or an aryl group that may have a substituted group represented by any of the following formulas (18) to (20), which may be the same or different,

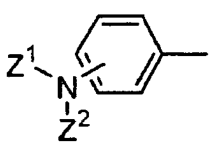

(18)

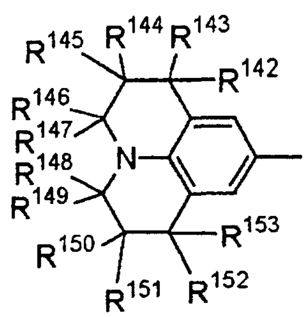

(19)

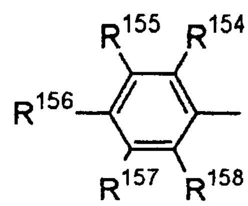

(20)

(wherein in the general formula (18), $Z^1$ and $Z^2$ are groups selected from a hydrogen atom, an alkyl group that may have a substituted group, or an aryl group that may have a substituted group, which may be the same or different, and
wherein in the general formulas (19) and (20), $R^{142}$ to $R^{158}$ are groups selected from a hydrogen atom, an alkyl group that may have a substituted group, an aryl group that may have a substituted group, an alkoxyl group that may have a substituted group, a halogen atom, a nitro group, a cyano group, and a trifluoromethyl group, which may be the same or different)].

**20.** An organic electroluminescence device according to Claim 19, wherein the organic layer has an organic laminated structure having a hole transport layer and an electron transport layer, wherein at least the electron transport layer of the organic layer is a mixture layer containing at least one aminostyryl compound represented by the general formula [I] or [II], and wherein the hole blocking layer is disposed on the cathode side of the mixture layer.

**21.** An organic electroluminescence device according to Claim 19, wherein the organic layer has an organic laminated structure having a hole transport layer and an electron transport layer, wherein at least the hole transport layer of the organic layer is a mixture layer containing at least one aminostyryl compound represented by the general formula [I] or [II], and wherein the hole blocking layer is disposed on the cathode side of the mixture layer.

**22.** An organic electroluminescence device according to Claim 19, wherein the organic layer has an organic laminated structure having a hole transport layer and an electron transport layer, wherein the hole transport layer is a mixture layer containing at least one aminostyryl compound represented by the general formula [I] or [II], wherein the electron transport layer is a mixture layer containing at least one aminostyryl compound represented by the general formula [I] or [II], and wherein the hole blocking layer is disposed on the cathode side of the mixture layer.

**23.** An organic electroluminescence device according to Claim 19, wherein the organic layer has an organic laminated structure having a hole transport layer, a light emitting layer, and an electron transport layer, wherein at least the light emitting layer of the organic layer is a mixture layer containing at least one aminostyryl compound represented by the general formula [I] or [II], and wherein the hole blocking layer is disposed on the cathode side of the mixture layer.

**24.** An organic electroluminescence device according to Claim 19, wherein the percentage of the aminostyryl compound in the mixture is 10 to 100% by weight.

**25.** An organic electroluminescence device comprising an organic layer having a light emitting area between an anode and a cathode, wherein at least a part of the organic layer consists of a mixture containing at least one aminostyryl compound represented by the following structural formulas (21)-1 to (21)-20, and wherein a hole blocking layer is disposed on the cathode side of the layer comprising the mixture,

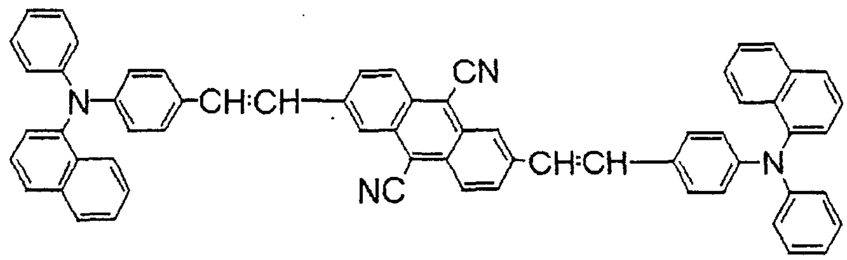

(21)-1

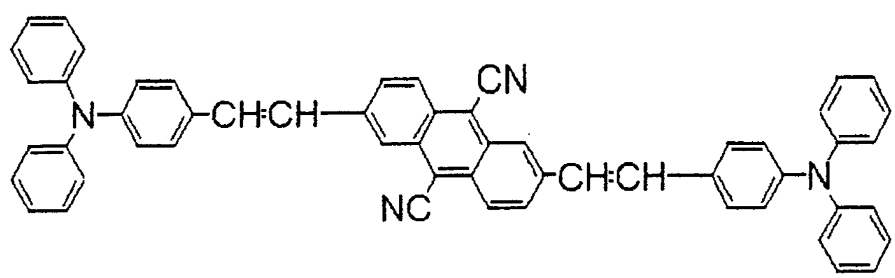

(21)-2

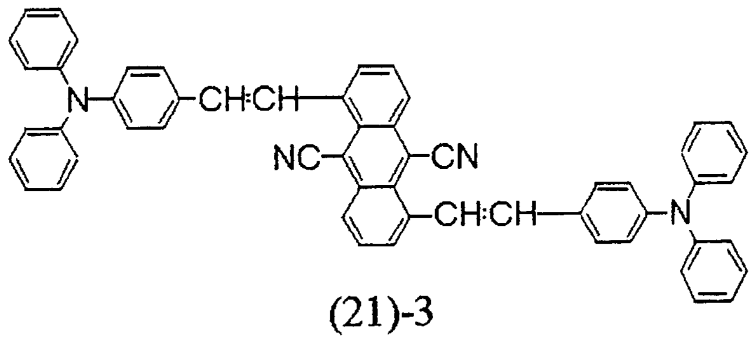

(21)-3

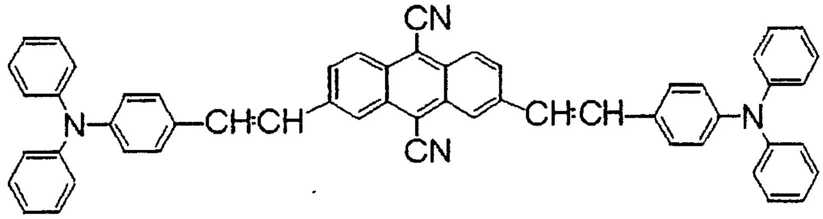

(21)-4

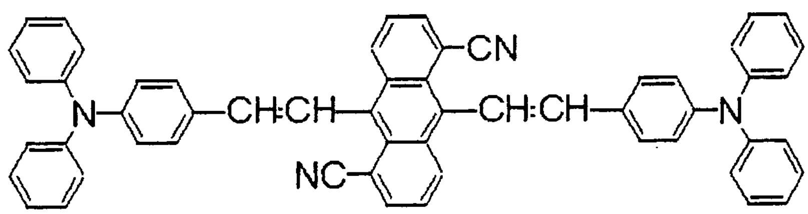

(21)-5

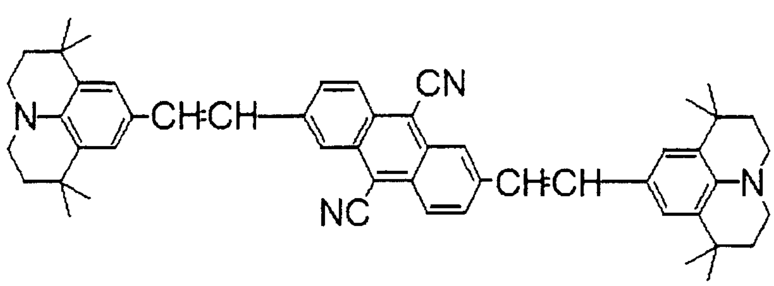

(21)-6

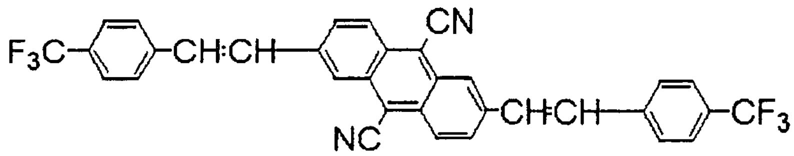

(21)-7

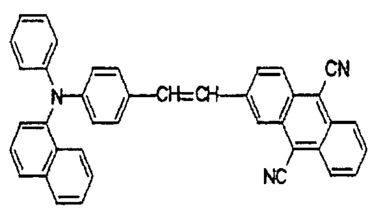

(21)-8

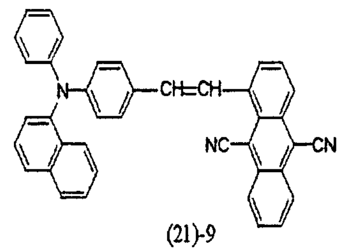

(21)-9

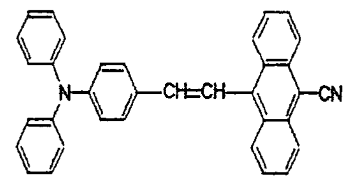

(21)-10

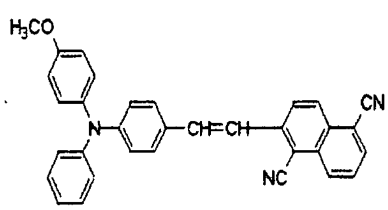

(21)-11

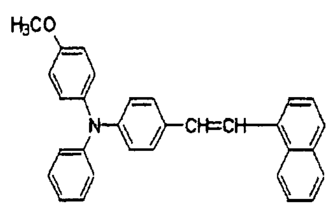

(21)-12

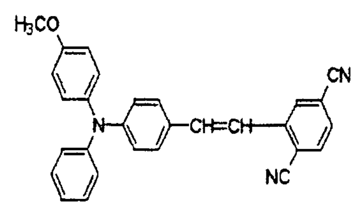

(21)-13

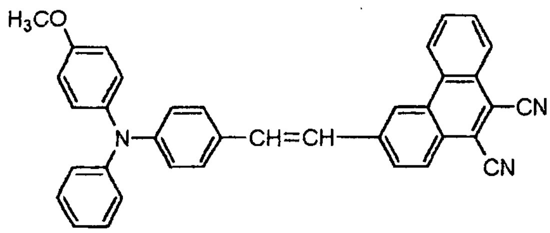

(21)-14

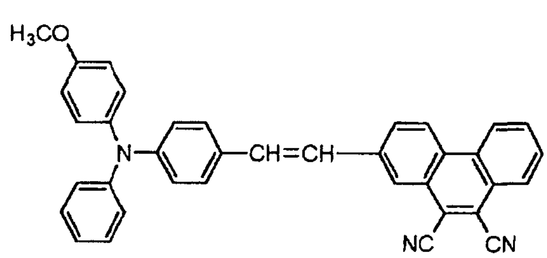

(21)-15

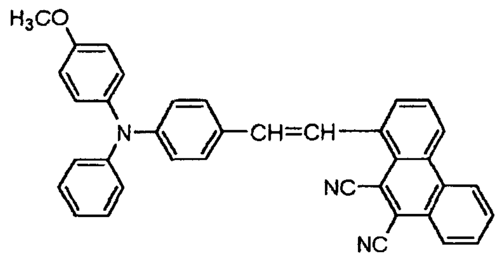

(21)-16

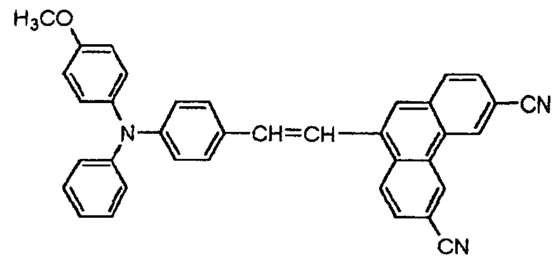

(21)-17

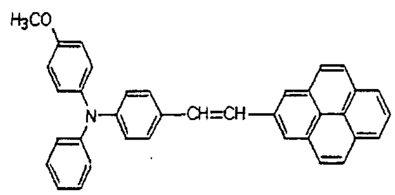

(21)-18

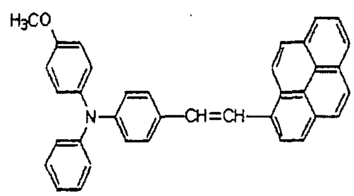

(21)-19

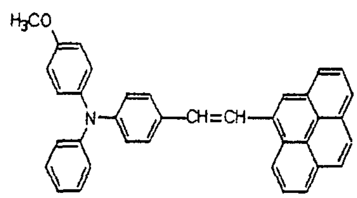

(21)-20

**26.** An organic electroluminescence device according to Claim 25, wherein the organic layer has an organic laminated structure having a hole transport layer and an electron transport layer, wherein at least the electron transport layer of the organic layer is a mixture layer containing at least one aminostyryl compound represented by the structural formulas (21)-1 to (21)-20, and wherein the hole blocking layer is disposed on the cathode side of the mixture layer.

**27.** An organic electroluminescence device according to Claim 25, wherein the organic layer has an organic laminated structure having a hole transport layer and an electron transport layer, wherein at least the hole transport layer of the organic layer is a mixture layer containing at least one aminostyryl compound represented by the structural formulas (21)-1 to (21)-20, and wherein the hole blocking layer is disposed on the cathode side of the mixture layer.

**28.** An organic electroluminescence device according to Claim 25, wherein the organic layer has an organic laminated structure having a hole transport layer and an electron transport layer, wherein the hole transport layer is a mixture layer containing at least one aminostyryl compound represented by the structural formulas (21)-1 to (21)-20, wherein the electron transport layer is a mixture layer containing at least one aminostyryl compound represented by the structural formulas (21)-1 to (21)-20, and wherein the hole blocking layer is disposed on the cathode side of the transport light emitting layer.

**29.** An organic electroluminescence device according to Claim 25, wherein the organic layer has an organic laminated structure having a hole transport layer, a light emitting layer, and an electron transport layer, wherein at least the light emitting layer of the organic layer is a mixture layer containing at least one aminostyryl compound represented by the structural formulas (21)-1 to (21)-20, and wherein the hole blocking layer is disposed on the cathode side of the mixture layer.

**30.** An organic electroluminescence device according to Claim 25, wherein the percentage of the aminostyryl compound in the mixture is 10 to 100% by weight.

**31.** An organic electroluminescence device comprising an organic layer having a light emitting area between an anode and a cathode, wherein at least a part of the organic layer consists of a mixture containing at least one aminostyryl compound represented by the following structural formulas (21)-1 to (21)-20, and a red light emitting dye having a light emission maximum within the range of 600 nm to 700 nm, and wherein a hole blocking layer is disposed on the cathode side of the layer comprising the mixture,

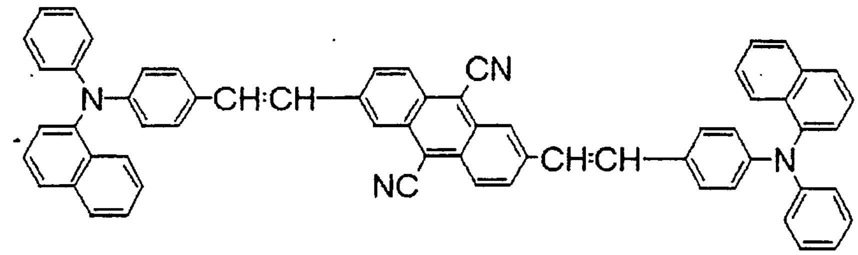

(21)-1

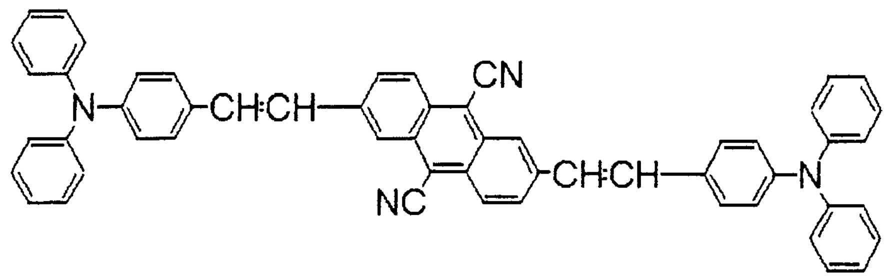

(21)-2

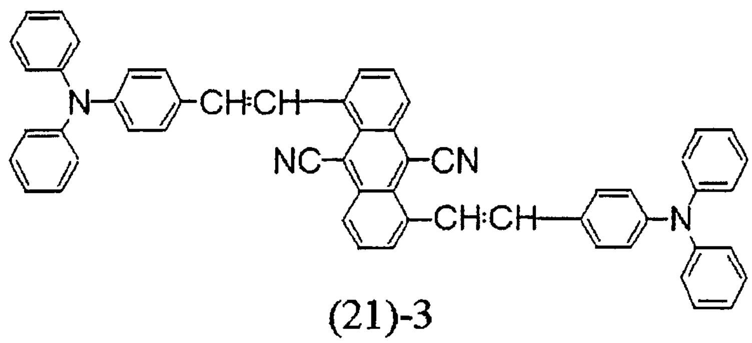

(21)-3

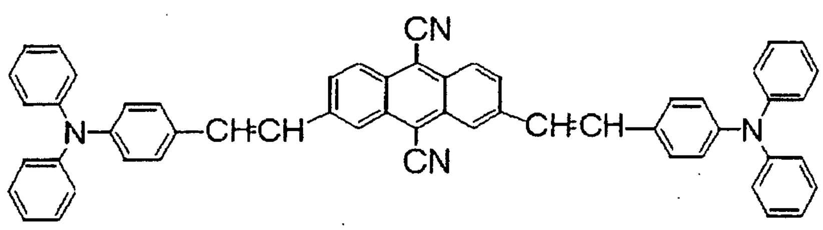

(21)-4

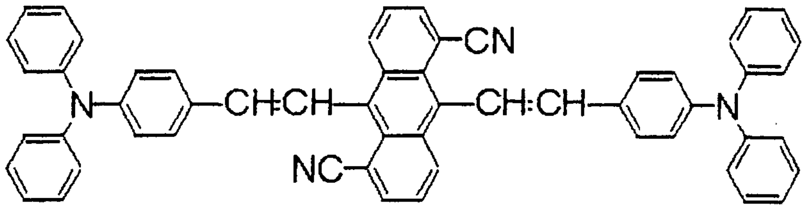

(21)-5

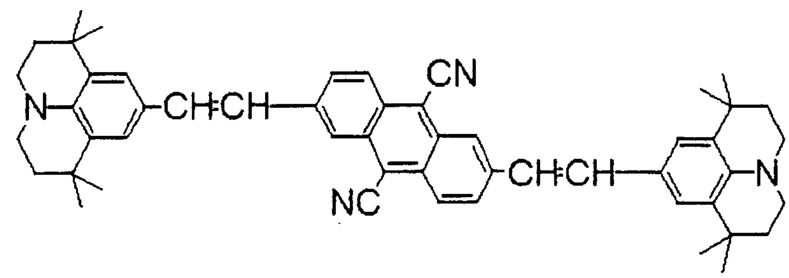

(21)-6

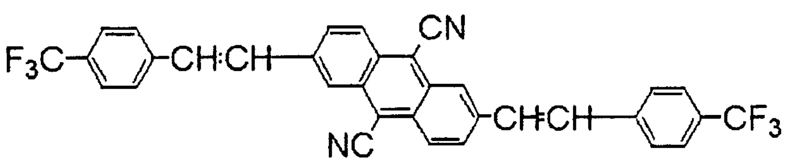

(21)-7

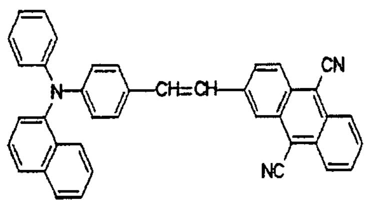

(21)-8

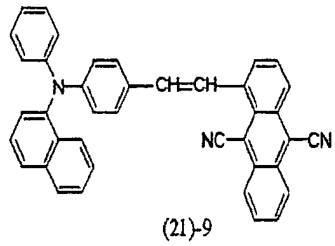

(21)-9

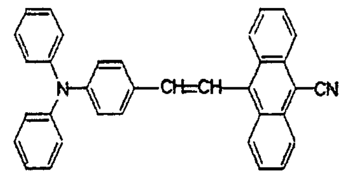

(21)-10

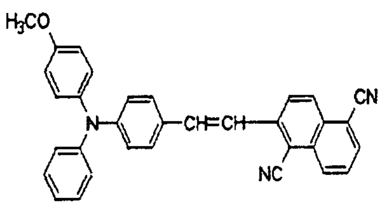

(21)-11

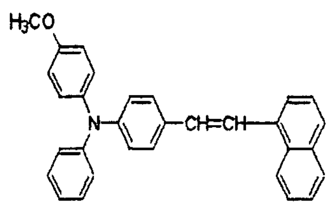

(21)-12

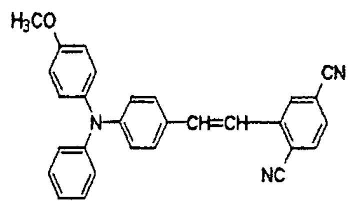

(21)-13

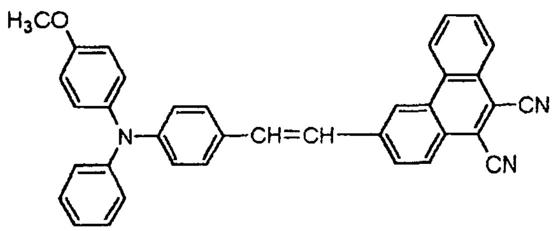

(21)-14

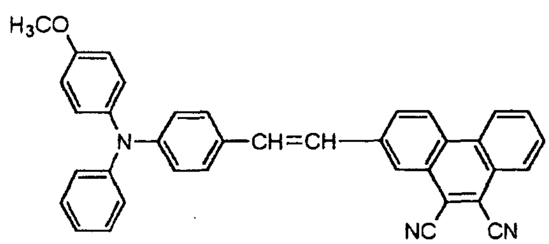

(21)-15

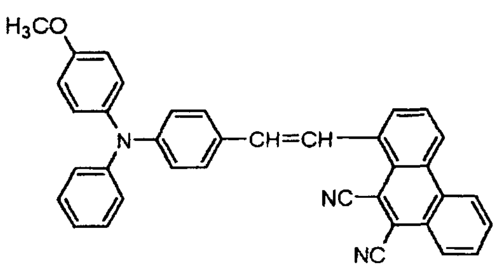

(21)-16

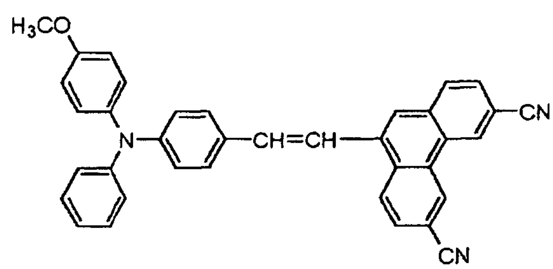

(21)-17

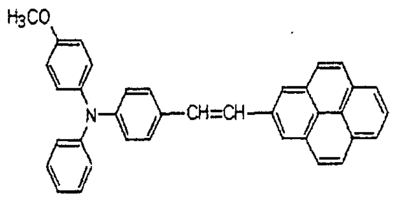

(21)-18

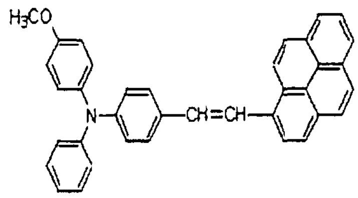

(21)-19

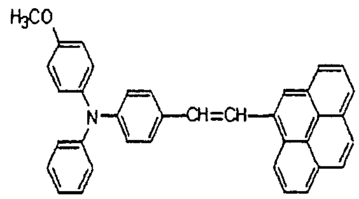

(21)-20

**32.** An organic electroluminescence device according to Claim 31, wherein the organic layer has an organic laminated structure having a hole transport layer and an electron transport layer, wherein at least the electron transport layer of the organic layer is a mixture layer containing at least one aminostyryl compound represented by the structural formulas (21)-1 to (21)-20, and wherein the hole blocking layer is disposed on the cathode side of the mixture layer.

**33.** An organic electroluminescence device according to Claim 31, wherein the organic layer has an organic laminated structure having a hole transport layer and an electron transport layer, wherein at least the hole transport layer of the organic layer is a mixture layer containing at least one aminostyryl compound represented by the structural formulas (21)-1 to (21)-20, and wherein the hole blocking layer is disposed on the cathode side of the mixture layer.

**34.** An organic electroluminescence device according to Claim 31, wherein the organic layer has an organic laminated structure having a hole transport layer and an electron transport layer, wherein the hole transport layer is a mixture layer containing at least one aminostyryl compound represented by the structural formulas (21)-1 to (21)-20, wherein the electron transport layer is a mixture layer containing at least one aminostyryl compound represented by the structural formulas (21)-1 to (21)-20, and wherein the hole blocking layer is disposed on the cathode side of the electron transport light emitting layer.

**35.** An organic electroluminescence device according to Claim 31, wherein the organic layer has an organic laminated structure having a hole transport layer, a light emitting layer, and an electron transport layer, wherein at least the light emitting layer of the organic layer is a mixture layer containing at least one aminostyryl compound represented by the structural formulas (21)-1 to (21)-20, and wherein the hole blocking layer is disposed on the cathode side of the mixture layer.

**36.** An organic electroluminescence device according to Claim 31, wherein the percentage of the aminostyryl compound in the mixture is 10 to 100% by weight.

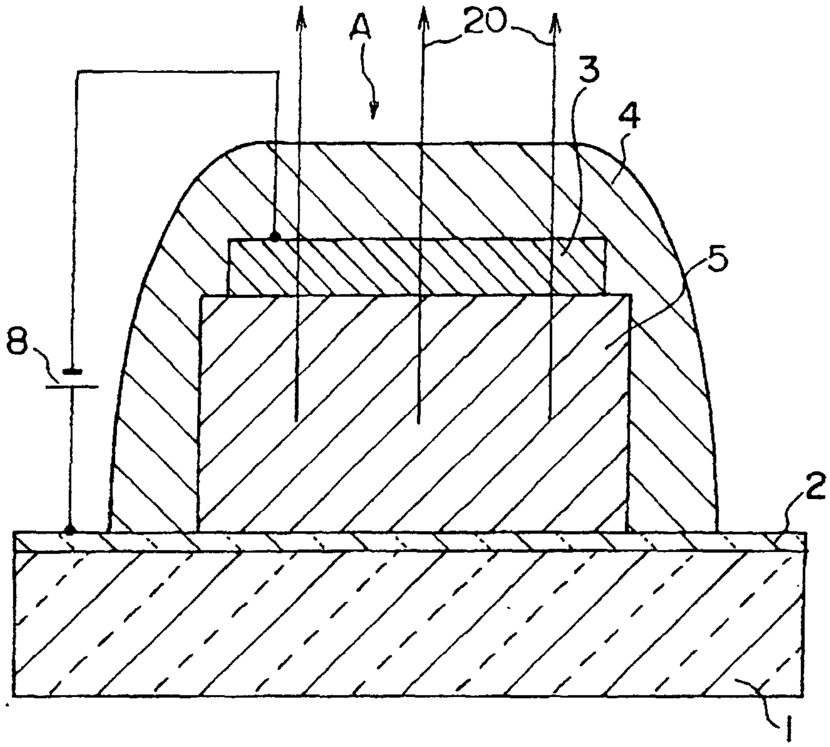


Fig.1

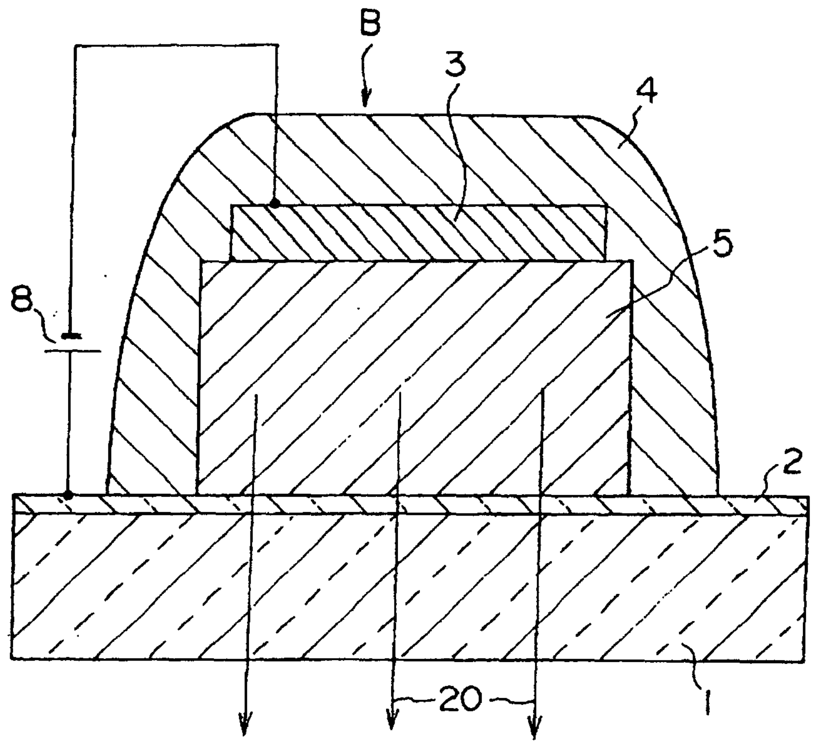


Fig.2

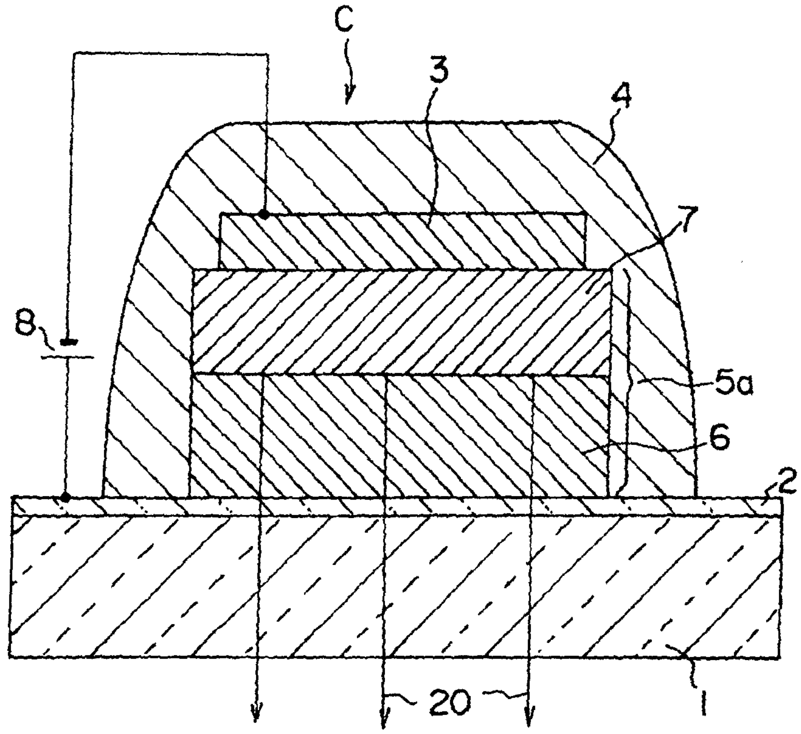


Fig.3

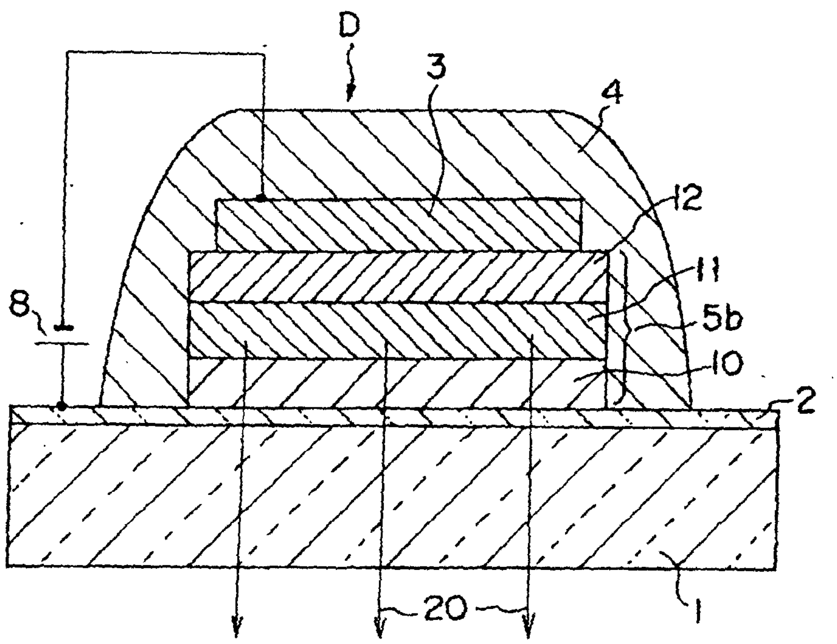


Fig.4

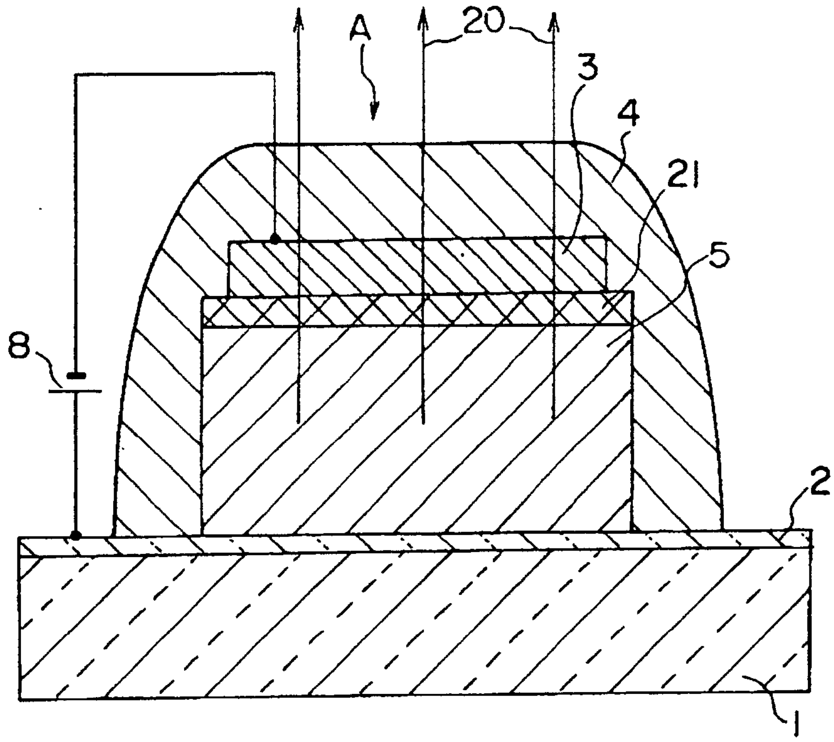


Fig.5

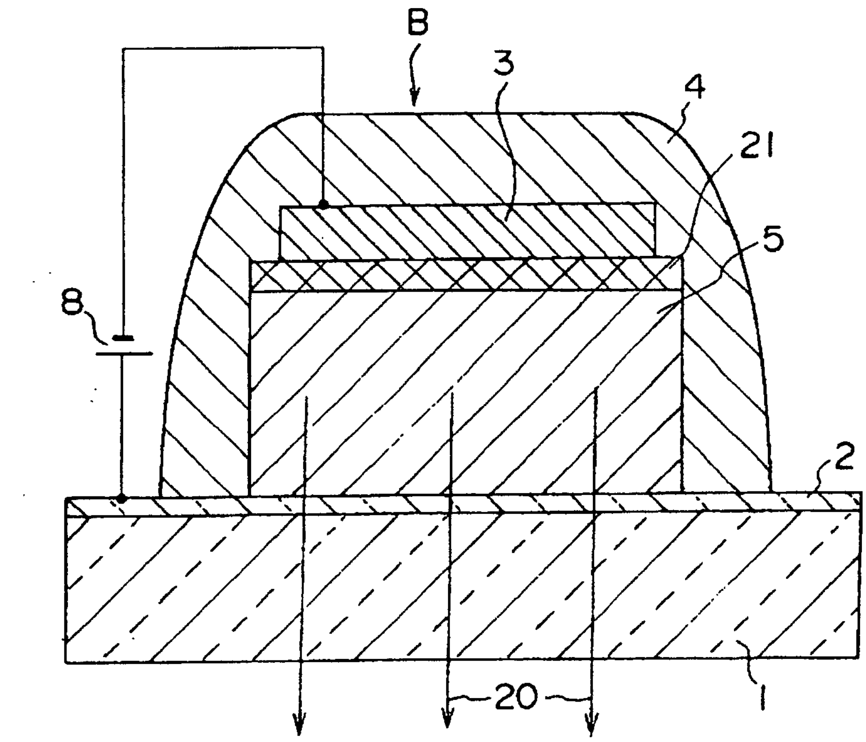


Fig.6

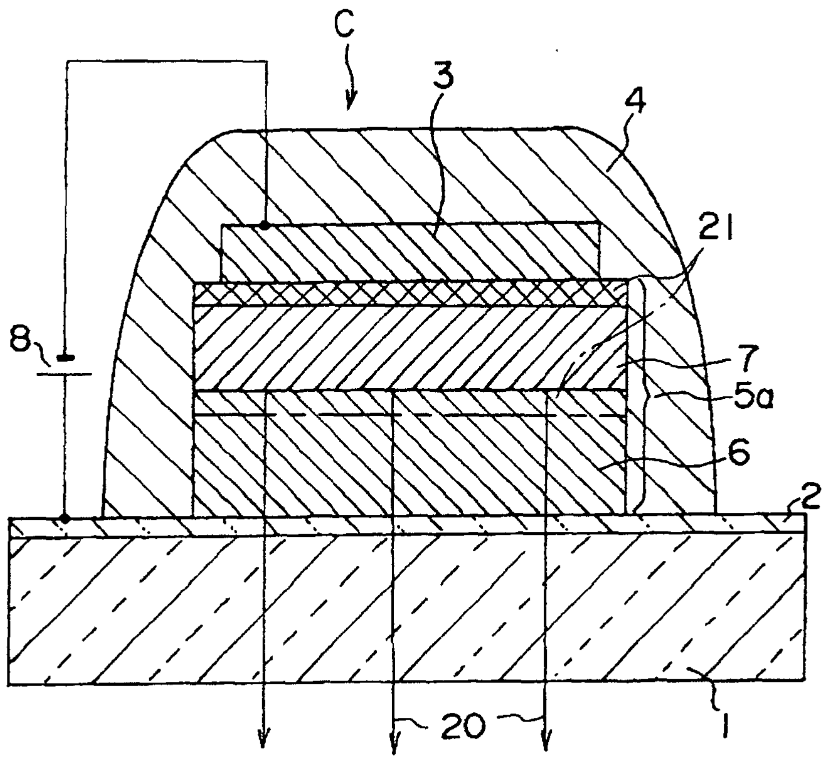


Fig.7

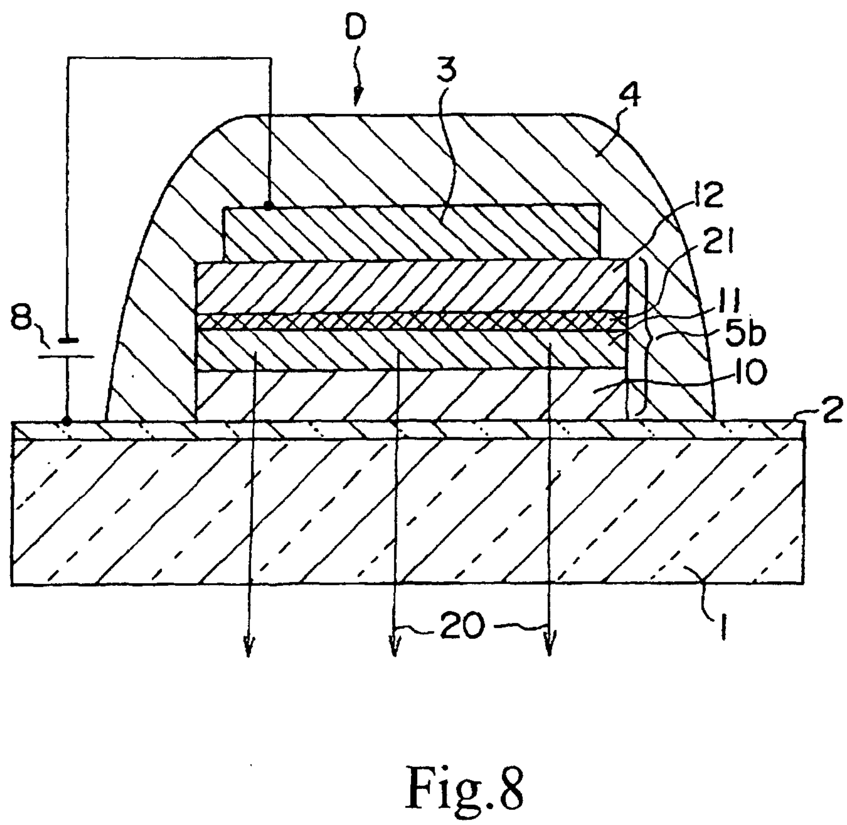


Fig.8

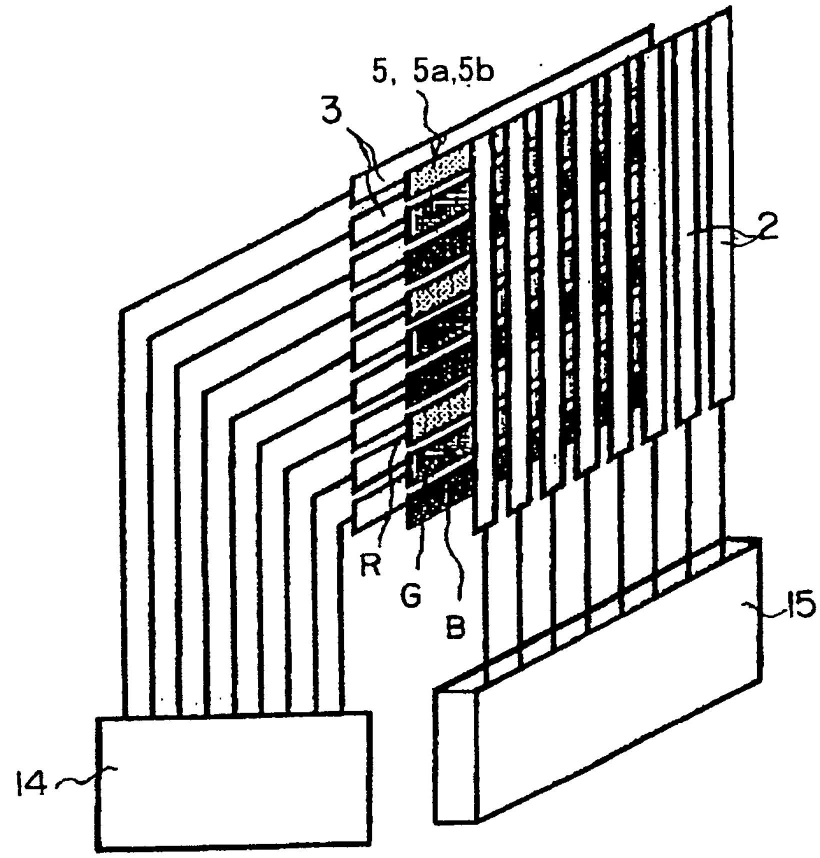


Fig.9

## INTERNATIONAL SEARCH REPORT

International application No.
PCT/JP02/04097

**A. CLASSIFICATION OF SUBJECT MATTER**
Int.Cl[7] C09K11/06, H05B33/14, H05B33/22

According to International Patent Classification (IPC) or to both national classification and IPC

**B. FIELDS SEARCHED**

Minimum documentation searched (classification system followed by classification symbols)
Int.Cl[7] C09K11/06, H05B33/14, H05B33/22

Documentation searched other than minimum documentation to the extent that such documents are included in the fields searched

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| E,X | JP 2002-134276 A (Sony Corp.), 10 May, 2002 (10.05.02), (Family: none) | 1-36 |
| X<br>Y | JP 5-41285 A (Ricoh Co., Ltd.), 19 February, 1993 (19.02.93), Claims; Par. No. [0005] (Family: none) | 1-12<br>13-36 |
| X<br>Y | JP 4-334894 A (Ricoh Co., Ltd.), 20 November, 1992 (20.11.92), Claims; Par. Nos. [0012] to [0014] (Family: none) | 1-12<br>13-36 |
| X<br>Y | JP 3-269995 A (Ricoh Co., Ltd.), 02 December, 1991 (02.12.91), Claims; page 3, upper right column to lower right column (Family: none) | 1-12<br>13-36 |

[X] Further documents are listed in the continuation of Box C. [ ] See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 17 July, 2002 (17.07.02) | 30 July, 2002 (30.07.02) |
| Name and mailing address of the ISA/<br>Japanese Patent Office | Authorized officer |
| Facsimile No. | Telephone No. |

Form PCT/ISA/210 (second sheet) (July 1998)

**INTERNATIONAL SEARCH REPORT**

International application No.
PCT/JP02/04097

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | WO 01/77065 A1 (Sony Corp.),<br>18 October, 2001 (18.10.01),<br>& JP 2001-288377 A | 1-12<br>13-36 |
| X<br>Y | EP 1072669 A2 (Sony Corp.),<br>31 January, 2001 (31.01.01),<br>& CN 1283073 A & KR 2001049922 A<br>& JP 2001-110570 A | 1-12,19-30<br>13-18,31-36 |
| X<br>Y | EP 1090911 A2 (Sony Corp.),<br>11 April, 2001 (11.04.01),<br>& JP 2001-106657 A | 1-12<br>13-36 |
| X<br>Y | JP 2000-173773 A (Sony Corp.),<br>23 June, 2000 (23.06.00),<br>Claims<br>(Family: none) | 1-6<br>19-24 |
| X<br>Y | JP 2000-91074 A (Sony Corp.),<br>31 March, 2000 (31.03.00),<br>Claims<br>(Family: none) | 1-12<br>13-36 |
| X<br>Y | JP 2000-91073 A (Sony Corp.),<br>31 March, 2000 (31.03.00),<br>Claims<br>(Family: none) | 1-12<br>13-36 |
| X<br>Y | EP 1072668 A2 (Sony Corp.),<br>31 January, 2001 (31.01.01),<br>& JP 2001-110571 A & CN 1283072 A<br>& KR 2001049923 A | 1-12,19-30<br>13-18,31-36 |
| Y | WO 01/77253 A1 (Sony Corp.),<br>18 October, 2001 (18.10.01),<br>& EP 1205528 A1 & JP 2001-291591 A | 13-36 |

Form PCT/ISA/210 (continuation of second sheet) (July 1998)

**INTERNATIONAL SEARCH REPORT**

International application No.
PCT/JP02/04097

**Box I Observations where certain claims were found unsearchable (Continuation of item 1 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box II Observations where unity of invention is lacking (Continuation of item 2 of first sheet)**

This International Searching Authority found multiple inventions in this international application, as follows:

The claims of this application involve five groups of inventions respectively having the following "technical features."

① An organic electroluminescent element containing either a compound represented by the formula [I] given in claims 1 to 6 and 19 to 24 or any of compounds represented by the formulae (21)-1 to (21)-7 given in claims 7 to 18 and 25 to 36.

② An organic electroluminescent element containing a compound represented

(continued to extra sheet)

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest** ☐ The additional search fees were accompanied by the applicant's protest.

☒ No protest accompanied the payment of additional search fees.

Form PCT/ISA/210 (continuation of first sheet (1)) (July 1998)

**INTERNATIONAL SEARCH REPORT**

International application No.
PCT/JP02/04097

Continuation of Box No. II of continuation of first sheet(1)

by the formula [II] given in claims 1 to 6 and 19 to 24 wherein Y3 is hydrogen or an optionally substituted alkyl.

③ An organic electroluminescent element containing either a compound represented by the formula [II] given in claims 1 to 6 and 19 to 24 wherein Y3 is represented by the formula (18) or any of compounds represented by the formulae (21)-8 to (21)-20 given in claims 7 to 18 and 25 to 36.

④ An organic electroluminescent element containing a compound represented by the formula [II] given in claims 1 to 6 and 19 to 24 wherein Y3 is represented by the formula (19).

⑤ An organic electroluminescent element containing a compound represented by the formula [II] given in claims 1 to 6 and 19 to 24 wherein Y3 is represented by the formula (20).

A "technical feature" common to the invention group ① and any one of the invention groups ② to ⑤ is an organic electroluminescent element containing a compound having a styryl skeleton. However, organic electroluminescent elements containing such a compound are so well known that there is no need of showing a document. Consequently, this "technical feature" is not considered to fall under the category of "special technical features" in the meaning of Rule 13.2 of the Regulations under the PCT.

A technical feature common to any two of the invention groups ② to ⑤ is an organic electroluminescent element containing a compound having a structure represented by -CH=-CH-X2. However, this is known because it is disclosed in, e.g., JP 5-41285 A and JP 4-368794 A. Consequently, this "technical feature" is not considered to fall under the category of "special technical features" in the meaning of Rule 13.2 of the Regulations under the PCT.

Therefore, any two of ①, ②, ③, ④, and ⑤ do not have a "special technical feature" common to both.

Form PCT/ISA/210 (extra sheet) (July 1998)